# EUROPÄISCHE PATENTSCHRIFT

(11) **EP 1 125 328 B1**
(45) Veröffentlichungstag und Bekanntmachung des Hinweises auf die Patenterteilung: **14.06.2006**
(21) Anmeldenummer: 00956125.9
(22) Anmeldetag: 08.08.2000
(51) Int. Cl.: H01L 21/8242

(54) **VERFAHREN ZUR HERSTELLUNG EINER DRAM-ZELLENANORDNUNG**
METHOD FOR PRODUCING A DRAM CELL ARRANGEMENT
PROCEDE DE PRODUCTION D'UN ENSEMBLE DE CELLULES DE MEMOIRE RAM DYNAMIQUE

(30) Priorität: 31.08.1999 DE 19941401
(43) Veröffentlichungstag der Anmeldung: 22.08.2001
(73) Patentinhaber: Infineon Technologies AG, 81669 München (DE)
(72) Erfinder: GOEBEL, Bernd, D-01099 Dresden (DE)
(74) Vertreter: Epping - Hermann - Fischer
(86) Internationale Anmeldenummer: PCT/DE2000/002647
(87) Internationale Veröffentlichungsnummer: WO 2001/017015

(56) Entgegenhaltungen:
- EP-A- 0 463 389
- US-A- 5 519 236
- US-A- 5 529 944
- US-A- 5 907 170
- PATENT ABSTRACTS OF JAPAN vol. 018, no. 080 (E-1505), 9. Februar 1994 (1994-02-09) -& JP 05 291528 A (TOSHIBA CORP), 5. November 1993 (1993-11-05)

## Beschreibung

Die Erfindung betrifft eine DRAM-Zellenanordnung, das heißt eine Speicherzellenanordnung mit dynamischem wahlfreiem Zugriff, dessen Speicherzellen jeweils einen Transistor und einen Kondensator umfassen.

Bei einer solchen DRAM-Zellenanordnung ist die Information einer Speicherzelle in Form einer Ladung auf dem Kondensator gespeichert. Der Transistor und der Kondensator der Speicherzelle sind derart miteinander verbunden, daß bei Ansteuerung des Transistors über eine Wortleitung die Ladung des Kondensators über eine Bitleitung ausgelesen werden kann.

Es wird allgemein angestrebt, eine DRAM-Zellenanordnung zu erzeugen, die eine hohe Packungsdichte, das heißt einen geringen Platzbedarf pro Speicherzelle, aufweist.

In der europäischen Patentschrift EP 0 852 396 ist eine DRAM-Zellenanordnung beschrieben, bei der zur Erhöhung der Pakkungsdichte ein Transistor einer Speicherzelle über einem Speicherkondensator der Speicherzelle angeordnet wird. Aktive Gebiete der Speicherzellen werden jeweils von einer isolierenden Struktur umgeben, die in einem Substrat angeordnet ist. Im Substrat wird für jede Speicherzelle eine Vertiefung erzeugt, in deren unteren Bereich ein Speicherknoten des Speicherkondensators und in deren oberen Bereich eine Gateelektrode des Transistors angeordnet sind. Ein oberes Source-/Drain-Gebiet, ein Kanalgebiet und ein unteres Source-/Drain-Gebiet des Transistors sind im Substrat übereinander angeordnet. Das untere Source-/Drain-Gebiet ist bei einer ersten Flanke der Vertiefung mit dem Speicherknoten verbunden. Die isolierende Struktur grenzt an eine zweite der ersten Flanke gegenüberliegenden Flanke der Vertiefung an, so daß der Speicherknoten dort nicht an das Substrat angrenzt. Eine Bitleitung grenzt an das obere Source-/Drain-Gebiet an und verläuft oberhalb des Substrats. Zur Herstellung der DRAM-Zellenanordnung wird zunächst die isolierende Struktur erzeugt. Auf einer Oberfläche des Substrats wird die Bitleitung erzeugt. Durch Diffusion von Dotierstoff aus der Bitleitung in das Substrat wird das obere Source-/Drain-Gebiet erzeugt. Angrenzend an die isolierende Struktur wird die Vertiefung erzeugt. Flanken der Vertiefung werden mit einem Kondensatordielektrikum versehen. Die Vertiefung wird bis zu einer ersten Höhe, die im Bereich der isolierenden Struktur liegt, mit dotiertem Polysilizium gefüllt. Freiliegende Teile des Kondensatordielektrikums werden entfernt. Anschließend wird die Vertiefung bis zu einer zweiten Höhe, die höher als die erste Höhe ist und im Bereich der isolierenden Struktur liegt, mit dotiertem Polysilizium gefüllt, so daß das Polysilizium einen Speicherknoten bildet, der an der ersten Flanke der Vertiefung zwischen der ersten Höhe und der zweiten Höhe an das Substrat angrenzt. Das untere Source-/Drain-Gebiete wird durch Diffusion von Dotierstoff aus dem Speicherknoten in das Substrat gebildet.

Der Erfindung liegt das Problem zugrunde, ein Verfahren zur Erzeugung einer DRAM-Zellenanordnung anzugeben, die im Vergleich zum Stand der Technik eine höhere Packungsdichte aufweist.

Das Problem wird durch ein Verfahren zur Herstellung einer DRAM-Zellenanordnung gelöst, bei dem in einem Substrat jeweils für einen Kondensator einer Speicherzelle der DRAM-Zellenanordnung eine Vertiefung erzeugt wird. In der Vertiefung werden eine Isolation und ein Speicherknoten des Kondensators, der mindestens teilweise durch die Isolation vom Substrat getrennt wird, erzeugt. Durch Silizium-Abscheiden, Rückätzen und schräge Implantation von Dotierstoff wird über dem Speicherknoten in der Vertiefung entlang Flanken der Vertiefung ein Spacer aus Silizium erzeugt, bei dem ein erster Teil des Spacers und ein zweiter, dem ersten Teil gegenüberliegender Teil des Spacers unterschiedlich dotiert sind. Der Spacer wird strukturiert, indem entweder der erste Teil des Spacers oder der zweite Teil des Spacers unter Ausnutzung ihrer unterschiedlichen Dotierung entfernt wird. Ein unter dem entfernten Teil des Spacers angeordneter erster Teil des Speicherknotens und die Isolation werden derart verändert, daß entweder der erste Teil des Speicherknotens oder ein unter dem verbleibenden Teil des Speichers angeordneter zweiter Teil des Speicherknotens an das Substrat angrenzt, wobei der strukturierte Spacer als Maske dient. Ein Transistor der Speicherzelle wird so erzeugt, daß ein erstes Source-/Drain-Gebiet im Substrat angrenzend an den Speicherknoten gebildet wird. Eine Wortleitung wird erzeugt und mit einer Gateelektrode des Transistors verbunden. Eine Bitleitung, die quer zur Wortleitung verläuft, wird erzeugt und mit der Speicherzelle verbunden.

Der Spacer besteht beispielsweise aus Polysilizium oder amorphem Silizium.

Der strukturierte Spacer wirkt als Maske, indem der verbleibende Teil des Spacers den zweiten Teil des Speicherknotens vor Prozeßschritten schützt.

Da der Speicherknoten nicht sowohl mit seinem ersten Teil als auch mit seinem zweiten Teil an das Substrat angrenzt, kann eine benachbarte Speicherzelle in unmittelbarer Nähe zur Vertiefung angeordnet werden, ohne daß es zu Leckströmen zwischen dem Speicherknoten und der benachbarten Speicherzelle kommt. Die Trennung des Speicherknotens von der benachbarten Speicherzelle erfolgt durch die Isolation in der Vertiefung. Eine Isolationsstruktur außerhalb der Vertiefung, die den Speicherknoten von der benachbarten Speicherzelle trennt, ist nicht erforderlich, so daß die DRAM-Zellenanordnung eine besonders hohe Packungsdichte aufweisen kann.

Die einseitige Veränderung des Speicherknotens und der Isolation erfolgt selbstjustiert, das heißt ohne Verwendung einer zu justierenden Maske. Dies ist im Hinblick auf eine hohe Packungsdichte ein großer Vorteil, da kein Platzbedarf für Justiertoleranzen berücksichtigt werden müssen.

Da außerhalb der Vertiefung angeordnete Isolationsstrukturen, die bis in Bereiche der ersten Source-/Drain-Gebiete der Transistoren der Speicherzellen reichen, nicht benötigt werden, ermöglicht die Erfindung die Herstellung einer DRAM-Zellenanordnung, bei der Kanalgebiete der Transistoren untereinander oder mit dem Substrat elektrisch verbunden sind. In diesem Fall können im Kanalgebiet erzeugte Ladungsträger abfließen, so daß sogenannte Floating-Body-Effekte, wie zum Beispiel eine Veränderung der Einsatzspannung des Transistors, vermieden werden.

Dazu ist es vorteilhaft, wenn nach Fertigstellung des Speicherknotens Dotierstoff bei einem Temperschritt aus dem Speicherknoten in das Substrat diffundiert und dort das erste Source-/Drain-Gebiet bildet. Insbesondere in diesem Fall besteht der Speicherknoten mindestens teilweise beispielsweise aus dotiertem Polysilizium.

Alternativ wird das erste Source-/Drain-Gebiet durch Strukturierung einer im Substrat vergrabenen dotierten Schicht erzeugt. Die dotierte Schicht wird durch die Vertiefungen und durch Isolationsgräben, die die dotierte Schicht durchtrennen, strukturiert. In diesem Fall sind die Kanalgebiete der Transistoren voneinander und vom Substrat elektrisch getrennt.

Es liegt im Rahmen der Erfindung, den Speicherknoten und die Isolation zunächst so zu erzeugen, daß sowohl der erste Teil des Speicherknotens als auch der zweite Teil des Speicherknotens an das Substrat angrenzen. Unter Verwendung des strukturierten Spacers als Maske wird der erste Teil des Speicherknotens anschließend entfernt. Die Isolation wird derart vergrößert, daß sie den ersten Teil des Speicherknotens ersetzt. Der Speicherknoten grenzt folglich nur mit seinem zweiten Teil an das Substrat an.

Im folgenden wird ein Verfahren beschrieben, durch das der Speicherknoten und die Isolation zunächst so erzeugt werden, daß sowohl der erste Teil des Speicherknotens als auch der zweite Teil des Speicherknotens an das Substrat angrenzen:

Nach Erzeugung der Vertiefung wird die Isolation so erzeugt, daß sie Flanken und einen Boden der Vertiefung bedeckt. Leitendes Material wird abgeschieden und bis zu einer ersten Höhe rückgeätzt. Anschließend werden freiliegende Teile der Isolation entfernt, so daß die Isolation ebenfalls nur bis zur ersten Höhe reicht. Durch Abscheiden von weiterem leitendem Material und Rückätzen bis zu einer zweiten Höhe, die oberhalb der ersten Höhe liegt, wird der Speicherknoten erzeugt, der zwischen der ersten Höhe und der zweiten Höhe an das Substrat angrenzt, während er unterhalb der ersten Höhe durch die Isolation vom Substrat getrennt ist.

Die Isolation kann nach Entfernung des ersten Teil des Speicherknotens vergrößert werden, indem isolierendes Material abgeschieden und rückgeätzt wird.

Es liegt im Rahmen der Erfindung, den Speicherknoten und die Isolation zunächst so zu erzeugen, daß weder der erste Teil noch der zweite Teil des Speicherknotens an das Substrat angrenzen. Unter Verwendung des strukturierten Spacers als Maske wird die Isolation im Bereich des ersten Teils des Speicherknotens entfernt. Durch Abscheiden und Rückätzen von leitendem Material wird anschließend der erste Teil des Speicherknotens vergrößert, so daß er an das Substrat angrenzt. In diesem Fall grenzt der Speicherknoten nur mit seinem ersten Teil an das Substrat an.

Dazu kann nach Erzeugung der Vertiefung die Isolation zunächst so erzeugt werden, daß sie die Flanken und den Boden der Vertiefung bedeckt. Anschließend wird leitendes Material abgeschieden und rückgeätzt. Der dadurch erzeugte Speicherknoten grenzt zunächst weder mit seinem ersten Teil noch mit seinem zweiten Teil an das Substrat an.

Es sollen nur einige Möglichkeiten beschrieben werden, wie der Spacer unter Ausnutzung der unterschiedlichen Dotierung des ersten Teils und des zweiten Teils strukturiert werden kann:

Wird der erste Teil des Spacers mit n-dotierenden Ionen dotiert, so kann der erste Teil des Spacers selektiv zum zweiten Teil des Spacers weggeätzt werden. Als Ätzmittel ist zum Beispiel HNO₃+COOH+HF geeignet. Der entfernte Teil des Spacers ist folglich der erste Teil des Spacers. Der verbleibende Teil des Spacers ist der zweite Teil des Spacers. Der zweite Teil des Spacers ist in diesem Fall vorzugsweise im wesentlichen undotiert.

Wird der erste Teil des Spacers mit p-dotierenden Ionen dotiert, so kann der zweite Teil des Spacers selektiv zum ersten Teil des Spacers weggeätzt werden. Als Ätzmittel ist zum Beispiel Cholin oder KOH geeignet. Der entfernte Teil des Spacers ist folglich der zweite Teil des Spacers, während der verbleibende Teil des Spacers der erste Teil des Spacers ist. Der zweite Teil des Spacers ist in diesem Fall vorzugsweise im wesentlichen undotiert.

Wird der Spacer bei der Implantation nicht in seiner gesamten vertikalen Ausdehnung implantiert, so ist unter dem ersten Teil des Spacers ein weiterer Teil des Spacers angeordnet. Dieser weitere Teil des Spacers ist nach Entfernung des ersten Teil des Spacers weiterhin über den ersten Teil des Speicherknotens angeordnet. Um den ersten Teil des Speicherknotens freizulegen, damit er verändert werden kann, wird der weitere Teil des Spacers entfernt. Dies kann durch anisotropes Ätzen erfolgen, wobei gleichzeitig der verbleibende Teil des Spacers angegriffen wird. Da jedoch der verbleibende Teil des Spacers eine größere vertikale Ausdehnung aufweist als der verbleibende Teil des Spacers, bedeckt der strukturierte Spacer auch nach Entfernung des weiteren Teils des Spacers den zweiten Teil des Speicherknotens und schützt ihn folglich.

Eine weitere Möglichkeit den Spacer zu strukturieren, besteht darin, bei n-dotiertem ersten Teil des Spacers zunächst eine thermische Oxidation durchzuführen. Da der erste Teil des Spacers eine höhere Konzentration von n-dotierenden Ionen aufweist als der zweite Teil des Spacers, wächst das Oxid auf dem ersten Teil des Spacers dicker auf als auf dem zweiten Teil des Spacers. Anschließend wird das Oxid geätzt, bis der zweite Teil des Spacers freigelegt wird. Da das Oxid auf dem ersten Teil des Spacers besonders dick ist, verbleibt ein Teil des Oxids auf dem ersten Teil des Spacers und schützt diesen. Beim Strukturieren des Spacers wird Silizium selektiv zum Oxid geätzt, so daß der zweite Teil des Spacers entfernt wird.

Dasselbe Prinzip kann angewandt werden, wenn der erste Teil des Spacers mit Stickstoff oder mit Sauerstoff implantiert wird. Bei Implantation mit Stickstoff wächst das Oxid auf dem ersten Teil langsamer als auf dem zweiten Teil auf. Bei Implantation mit Sauerstoff wächst das Oxid auf dem zweiten Teil langsamer als auf dem ersten Teil auf.

Um sicherzustellen, daß bei der Implantation des ersten Teil des Spacers der Dotierstoff bis zum der Flanke zugewandten Rand des Spacers gelangt, ist es vorteilhaft, einen Temperschritt durchzuführen, bei dem der Dotierstoff diffundieren kann.

Zur Prozeßvereinfachung und zur Erhöhung der Prozeßsicherheit ist es vorteilhaft, den verbleibenden Teil des Spacers als Platzhalter für die Gateelektrode zu verwenden. Der verbleibende Teil des Spacers wird in diesem Fall nach Fertigstellung des Speicherknotens entfernt und zumindest teilweise durch die Gateelektrode ersetzt. Der Herstellungsprozeß ist besonders einfach, da die Gateelektrode selbstjustiert, das heißt ohne Verwendung einer zu justierenden Maske, erzeugt wird. Damit die Gateelektrode vom Speicherknoten elektrisch isoliert wird, wird vor Erzeugung des Spacers eine isolierende Schicht auf dem Speicherknoten erzeugt. Der Spacer wird auf der isolierenden Schicht erzeugt. Diese isolierende Schicht trennt folglich auch die Gateelektrode vom Speicherknoten. Um zu seiner Veränderung den ersten Teil des Speicherknotens freizulegen, wird nach Strukturierung des Spacers ein freiliegender Teil der isolierenden Schicht entfernt.

Ein zweites Source-/Drain-Gebiet des Transistors wird oberhalb des ersten Source-/Drain-Gebiets des Transistors erzeugt, so daß der Transistor als vertikaler Transistor gebildet wird. Ein solche DRAM-Zellenanordnung kann aufgrund der vertikalen Ausbildung des Transistors eine besonders hohe Packungsdichte aufweisen. Da die Gateelektrode oberhalb des zweiten Teils des Speicherknotens gebildet wird, sollte in diesem Fall das erste Source/Drain-Gebiet an den zweiten Teil des Speicherknotens angrenzen. Der zweite Teil des Speicherknotens grenzt also an das Substrat an, während der erste Teil des Speicherknotens nicht an das Substrat angrenzt. Da die Gateelektrode von Teilen des Substrats, die im Bereich des ersten Teils des Speicherknotens angeordnet sind, beabstandet ist, wird die Ausbildung einer Kapazität zwischen der Gateelektrode und dem Substrat verhindert.

Die Wortleitung kann beispielsweise oberhalb des Substrats erzeugt werden und an einen oberen Teil der Gateelektrode angrenzen.

Die Isolation wird beispielsweise vergrößert, indem isolierendes Material abgeschieden und rückgeätzt wird, bis der verbleibende Teil des Spacers freigelegt wird.

Für den Fall, daß der verbleibende Teil des Spacers als Platzhalter für die Gateelektrode dient, ist es vorteilhaft, wenn der verbleibende Teil des Spacers bei der Strukturierung des Spacers nicht angegriffen wird. Insbesondere bei Entfernung des ersten Teils des Spacers selektiv zum zweiten Teil des Spacers ist es vorteilhaft, wenn unter dem ersten Teil des Spacers kein weiterer Teil des Spacers angeordnet ist. Das heißt, daß der erste Teil des Spacers die gesamte vertikale Ausdehnung des Spacers umfaßt. Die schräge Implantation erfolgt in diesem Fall unter einem Winkel, bei dem der Spacer in seiner gesamten vertikalen Ausdehnung implantiert wird.

Für den Fall, daß eine solche schräge Implantation nicht durchgeführt wird, das heißt untere Bereiche des Spacers nicht implantiert werden, ist es vorteilhaft, einen Temperschritt durchzuführen, bei dem Dotierstoff aus dem ersten Teil des Spacers in den darunterliegenden weiteren Teil des Spacers diffundiert. Dadurch kann der weitere Teil des Spacers ebenfalls selektiv zum zweiten Teil des Spacers weggeätzt werden, so daß der zweite Teil des Spacers nicht angegriffen wird.

Um zu verhindern, daß dabei Dotierstoff aus dem ersten Teil des Spacers in den zweiten Teil des Spacers diffundiert, ist es vorteilhaft, den Spacer vor dem Temperschritt aufzutrennen so daß der erste Teil des Spacers vom zweiten Teil des Spacers elektrisch getrennt wird.

Eine solche Auftrennung kann beispielsweise durch maskiertes Ätzen des Spacers erfolgen.

Zur Erhöhung der Prozeßsicherheit ist es jedoch vorteilhaft, wenn die Auftrennung selbstjustiert, das heißt ohne Verwendung einer zu justierenden Maske, erfolgt. Dazu kann auf dem Substrat eine erste Hilfsschicht erzeugt werden, in der im wesentlichen parallel zueinander verlaufende, nebeneinander angeordnete Hilfsgräben erzeugt werden, die die erste Hilfs-schicht nicht durchtrennen. Die Vertiefungen für die Kondensatoren der Speicherzellen werden auch in den Hilfsgräben erzeugt. Nach Erzeugung des Spacers wird eine zweite Hilfsschicht aus einem ersten Material, das selektiv zu Silizium ätzbar ist, im wesentlichen konform abgeschieden, wobei die zweite Hilfsschicht so dünn ist, daß die Hilfsgräben nicht aufgefüllt werden. Ein zweites Material, das selektiv zum ersten Material ätzbar ist, wird abgeschieden und rückgeätzt, bis das zweite Material als streifenförmige Struktur nur noch innerhalb der Hilfsgräben vorhanden ist. Freigelegte Teile der zweiten Hilfsschicht werden selektiv zum zweiten Material entfernt, so daß der Spacer teilweise freigelegt wird. Anschließend wird Silizium geätzt, bis der Spacer aufgetrennt wird. Der aufgetrennte Spacer wird anschließend strukturiert.

Es ist vorteilhaft, die erste Hilfsschicht und die zweite Hilfsschicht, die als Maske bei der Auftrennung des Spacers wirken, zu verwenden, um den Speicherknoten so zu verändern, daß er vor Veränderung seines ersten Teils nur noch mit seinem ersten Teil und mit seinem zweiten Teil an das Substrat angrenzt. Dazu wird unter Verwendung der ersten Hilfsschicht und der zweiten Hilfsschicht als Maske Teile des Speicherknotens entfernt und durch isolierendes Material ersetzt. Alternativ können Isolationsgräben erzeugt werden, die bis in den Bereich des Speicherknotens reichen und dort den Speicherknoten vom Substrat trennen.

Dient der verbleibende Teil des Spacers als Platzhalter für die Gateelektrode, so bewirkt die Auftrennung des Spacers eine Beschränkung der Kanalweite des Transistors. Dies ist insbesondere dann vorteilhaft, wenn die Vertiefung gekrümmte Flanken aufweist. Bekanntlich ist die Qualität eines durch thermische Oxidation aufgewachsenen Gatedielektrikums an gekrümmten Flächen schlechter als an ebenen Flächen. Es ist folglich vorteilhaft, den Kanal auf ebene Abschnitte der Flanken der Vertiefung zu begrenzen.

Im folgenden wird ein Verfahren beschrieben, wie das zweite Source-/Drain-Gebiet erzeugt werden kann:

Nach Veränderung der Isolation und des Speicherknotens wird isolierendes Material abgeschieden und rückgeätzt, bis der verbleibende Teil des Spacers freigelegt wird. Der verbleibende Teil des Spacers wird entfernt. Eine dritte Hilfsschicht wird in einer solchen Dicke abgeschieden, daß die Hilfsgräben nicht aufgefüllt werden. Ein drittes Material wird abgeschieden und rückgeätzt, bis das dritte Material nur noch innerhalb der Hilfsgräben vorhanden ist und in den Hilfsgräben jeweils eine streifenförmige Maske bildet. Freiliegende Teile der dritten Hilfsschicht werden selektiv zur Maske entfernt. Teile der ersten Hilfsschicht, die außerhalb der Maske angeordnet sind, werden entfernt, und darunter angeordnete Teile des Substrats werden freigelegt. Anschließend wird das Substrat selektiv zur Maske geätzt, so daß Isolationsgräben erzeugt werden. Anschließend werden die Maske und die erste Hilfsschicht entfernt. In ehemals unter der Maske angeordneten Teilen des Substrats werden die zweiten Source-/Drain-Gebiete erzeugt. Die Isolationsgräben werden so erzeugt, daß sie tiefer als die zweiten Source-/Drain-Gebiete sind. Die zweiten Source-/Drain-Gebiete sind im Bereich der Hilfsgräben und jeweils zwischen zwei der Vertiefungen angeordnet. Die zweiten Source-/Drain-Gebiete werden durch die Vertiefungen und durch die Isolationsgräben voneinander getrennt.

Die zweiten Source-/Drain-Gebiete können durch Implantation nach Entfernung der Maske und der ersten Hilfsschicht erzeugt werden. Alternativ werden die zweiten Source-/Drain-Gebiete durch Strukturierung einer im Bereich der Oberfläche des Substrats erzeugten dotierten Schicht erzeugt, indem diese dotierte Schicht durch die Vertiefungen und durch die Isolationsgräben strukturiert wird.

Damit eine Abmessung der zweiten Source-/Drain-Gebiete der Kanalweite entspricht, ist es vorteilhaft, wenn eine Dicke der dritten Hilfsschicht der Summe aus der Dicke des Spacers und der zweiten Hilfsschicht entspricht.

Zur Prozeßvereinfachung und zur Erhöhung der Prozeßgenauigkeit ist es vorteilhaft, wenn die Vertiefungen selbstjustiert derart in den Hilfsgräben erzeugt werden, daß ihr horizontaler Querschnitt jeweils von einer Flanken bis zur anderen Flanke des entsprechenden Hilfsgrabens reicht.

Dazu wird beispielsweise über der ersten Hilfsschicht vor deren Strukturierung eine erste Maskenschicht und darüber eine zweite Maskenschicht abgeschieden. Anschließend werden die Hilfsgräben erzeugt, wobei auch die erste Maskenschicht und die zweite Maskenschicht durchtrennt werden. Anschließend werden erste isolierende Strukturen erzeugt, indem Material abgeschieden und rückgeätzt wird, bis die zweite Maskenschicht freigelegt wird. Mit Hilfe einer streifenförmigen Photolackmaske, deren Streifen quer zu den Hilfsgräben verlaufen, werden die ersten isolierenden Strukturen selektiv zur Photolackmaske und zur zweiten Maskenschicht geätzt, bis die Hilfsgräben teilweise freigelegt werden. Die freigelegten Teile der ersten Hilfsschicht an den Böden der Hilfsgräben werden entfernt, bis das Substrat teilweise freigelegt wird. Die freigelegten Teile des Substrats werden anschließend geätzt, so daß die Vertiefungen erzeugt werden. Die erste Maskenschicht und die ersten isolierenden Strukturen dienen dabei als Maske.

Zur Vermeidung von Leckströmen aufgrund Ausbildung lokaler Feldspitzen an Kanten der Vertiefungen ist es vorteilhaft, Abrundungselemente zu erzeugen, die ebenfalls als Maske bei der Erzeugung der Vertiefungen dienen. Dazu wird Material der ersten Maskenschicht abgeschieden, rückgeätzt und anschließend isotrop geätzt, so daß das erste Material Kanten, die innerhalb der ersten Hilfsschicht gebildet werden, abrundet. Die anschließend erzeugten Vertiefungen weisen keine Kanten auf.

Die Isolation in den Vertiefungen dient mindestens teilweise als Kondensatordielektrikum der Kondensatoren. Kondensatorelektroden der Kondensatoren werden als dotierte Gebiete im Substrat angrenzend am Kondensatordielektrikum gebildet. Die Kondensatorelektroden können zusammenhängen und eine gemeinsame Kondensatorelektrode aller Kondensatoren bilden. Die Kondensatorelektroden können beispielsweise durch Ausdiffusion von Dotierstoff aus einer Dotierstoffquelle, die in die Vertiefungen eingebracht wird, erzeugt werden. Alternativ werden die Kondensatorelektroden aus einer im Substrat vergrabenen dotierten Schicht erzeugt.

Es liegt im Rahmen der Erfindung, die Isolation oberhalb der Kondensatorelektrode besonders dick auszugestalten.

Der Spacer wird erzeugt, indem Silizium abgeschieden und rückgeätzt wird. Die schräge Implantation kann vor oder nach dem Rückätzen erfolgen.

Im folgenden wird ein Ausführungsbeispiel der Erfindung anhand der Figuren näher erläutert.
- Figur 1a: zeigt einen Querschnitt durch ein Substrat, nachdem eine erste Hilfsschicht, eine erste Maskenschicht, eine zweite Maskenschicht und Hilfsgräben erzeugt wurden.
- Figur 1b: zeigt einen zum Querschnitt aus Figur 1a senkrechten Querschnitt durch das Substrat nach den Prozeßschritten aus Figur 1a.
- Figur 1c: zeigt eine Aufsicht auf das Substrat nach den Prozeßschritten aus Figur 1a, in der die Hilfsgräben und die zweite Maskenschicht dargestellt sind.
- Figur 2a: zeigt den Querschnitt aus Figur 1a, nachdem erste isolierende Strukturen erzeugt wurden.
- Figur 2b: zeigt den Querschnitt aus Figur 1b nach den Prozeßschritten aus Figur 2a.
- Figur 3a: zeigt den Querschnitt aus Figur 2a, nachdem Teile der Böden der Hilfsgräben freigelegt wurden.
- Figur 3b: zeigt den Querschnitt aus Figur 2b nach den Prozeßschritten aus Figur 3a.
- Figur 3c: zeigt die Aufsicht aus Figur 1c nach den Prozeßschritten aus Figur 3a, in der die zweite Maskenschicht, die ersten isolierenden Strukturen und die freigelegten Böden der ersten Hilfsschicht dargestellt sind.
- Figur 4: zeigt die Aufsicht aus Figur 3c, nachdem Teile des Substrats freigelegt wurden, die zweite Maskenschicht entfernt wurde und Abrundungselemente erzeugt wurden. In dieser Aufsicht sind die Abrundungselemente, die erste Maskenschicht, die freigelegten Teile des Substrats und die ersten isolierenden Strukturen dargestellt.
- Figur 5a: zeigt den Querschnitt aus Figur 3a nach den Prozeßschritten aus Figur 4 und nachdem Vertiefungen, eine Kondensatorelektrode, Isolationen, Speicherknoten und eine isolierende Schicht erzeugt wurden und die erste Maskenschicht entfernt wurde.
- Figur 5b: zeigt den Querschnitt aus Figur 3b nach den Prozeßschritten aus Figur 5a.
- Figur 6a: zeigt den Querschnitt aus Figur 5a, nachdem ein Schutzoxid erzeugt wurde und amorphes Silizium abgeschieden und schräg implantiert wurde.
- Figur 6b: zeigt den Querschnitt aus Figur 5b nach den Prozeßschritten aus Figur 6a.
- Figur 7a: zeigt den Querschnitt aus Figur 6a, nachdem Spacer, eine zweite Hilfsschicht und streifenförmige Strukturen erzeugt wurden.
- Figur 7b: zeigt den Querschnitt aus Figur 6b nach den Prozeßschritten aus Figur 7a.
- Figur 7c: zeigt die Aufsicht aus Figur 4 nach den Prozeßschritten nach Figur 7a. In dieser Aufsicht sind die streifenförmigen Strukturen und freiliegende Teile der zweiten Hilfsschicht dargestellt.
- Figur 8a: zeigt den Querschnitt aus Figur 7a, nachdem freiliegende Teile der zweiten Hilfsschicht freigelegt, die Spacer aufgetrennt, die isolierende Schicht teilweise entfernt und die Speicherknoten angeätzt wurden.
- Figur 8b: zeigt den Querschnitt aus Figur 7b nach den Prozeßschritten aus Figur 8a.
- Figur 8c: zeigt die Aufsicht auf Figur 7b nach den Prozeßschritten aus Figur 8a. In dieser Aufsicht sind Teile der zweiten Hilfsschicht, freigelegte Teile der Isolationen und der Speicherknoten, Teile der Böden der Hilfsgräben sowie außerhalb der Böden angeordnete Teile der ersten Hilfsschicht dargestellt.
- Figur 9a: zeigt den Querschnitt aus Figur 8a, nachdem die Isolationen vergrößert, die Spacer freigelegt und Dotierstoff aus ersten Teilen der Spacer diffundiert ist.
- Figur 9b: zeigt den Querschnitt aus Figur 8b nach den Prozeßschritten aus Figur 9a.
- Figur 10a: zeigt den Querschnitt aus Figur 9a, nachdem erste Teile der Spacer entfernt, Teile der isolierenden Schicht entfernt, erste Teile der Speicherknoten entfernt und die Isolationen vergrößert wurden.
- Figur 10b: zeigt den Querschnitt aus Figur 9b nach den Prozeßschritten aus Figur 10a.
- Figur 10c: zeigt die Aufsicht auf Figur 8c nach den Prozeßschritten aus Figur 10a. In dieser Aufsicht sind die zweiten Teile der Spacer, die Isolationen und die erste Hilfsschicht dargestellt.
- Figur 11a: zeigt den Querschnitt aus Figur 10a, nachdem die zweiten Teile der Spacer entfernt wurden und eine dritte Hilfsschicht und eine Maske erzeugt wurden.
- Figur 11b: zeigt den Querschnitt aus Figur 10b nach den Prozeßschritten aus Figur 11a.
- Figur 11c: zeigt die Aufsicht auf Figur 10c nach den Prozeßschritten aus Figur 11a. In dieser Aufsicht sind die Maske und freiliegende Teile der dritten Hilfsschicht dargestellt.
- Figur 12: zeigt den Querschnitt aus Figur 11b, nachdem freiliegende Teile der dritten Hilfsschicht und darunter angeordnete Teile der ersten Hilfsschicht entfernt wurden.
- Figur 13a: zeigt den Querschnitt aus Figur 11a nach den Prozeßschritten aus Figur 12 und nachdem Isolationsgräben erzeugt und die Maske und die erste Hilfsschicht entfernt wurden.
- Figur 13b: zeigt den Querschnitt aus Figur 12 nach den Prozeßschritten aus Figur 13a.
- Figur 14a: zeigt den Querschnitt aus Figur 13a, nachdem die dritte Hilfsschicht entfernt wurde und zweite Source-/Drain-Gebiete, ein Gatedielektrikum, Gateelektroden, Wortleitungen, zweite isolierende Strukturen, eine Schutzschicht und erste Source-/Drain-Gebiete erzeugt wurden.
- Figur 14b: zeigt den Querschnitt aus Figur 13b nach den Prozeßschritten aus Figur 14a.
- Figur 14c: zeigt die Aufsicht aus Figur 11c nach den Prozeßschritten aus Figur 14a. In dieser Aufsicht sind die Vertiefungen, die Wortleitungen, die Isolationsgräben und die zweiten Source-/Drain-Gebiete dargestellt.
- Figur 15a: zeigt den Querschnitt aus Figur 14a, nachdem ein Zwischenoxid, Kontakte und Bitleitungen erzeugt wurden.
- Figur 15b: zeigt den Querschnitt aus Figur 14b nach den Prozeßschritten aus Figur 15a.
- Figur 15c: zeigt die Aufsicht auf Figur 14c nach den Prozeßschritten aus Figur 15a. In dieser Aufsicht sind die Vertiefungen, die Isolationsgräben, die Wortleitungen und die Bitleitungen dargestellt.

Die Figuren sind nicht maßstabsgetreu.

Im Ausführungsbeispiel ist als Ausgangsmaterial ein Substrat 1 vorgesehen, das im wesentlichen aus p-dotiertem Silizium mit einer Dotierstoffkonzentration von ca. 10¹⁵ cm⁻³ besteht. Auf einer Oberfläche O des Substrats 1 wird SiO₂ durch thermische Oxidation ca. 8 nm dick aufgewachsen (nicht dargestellt).

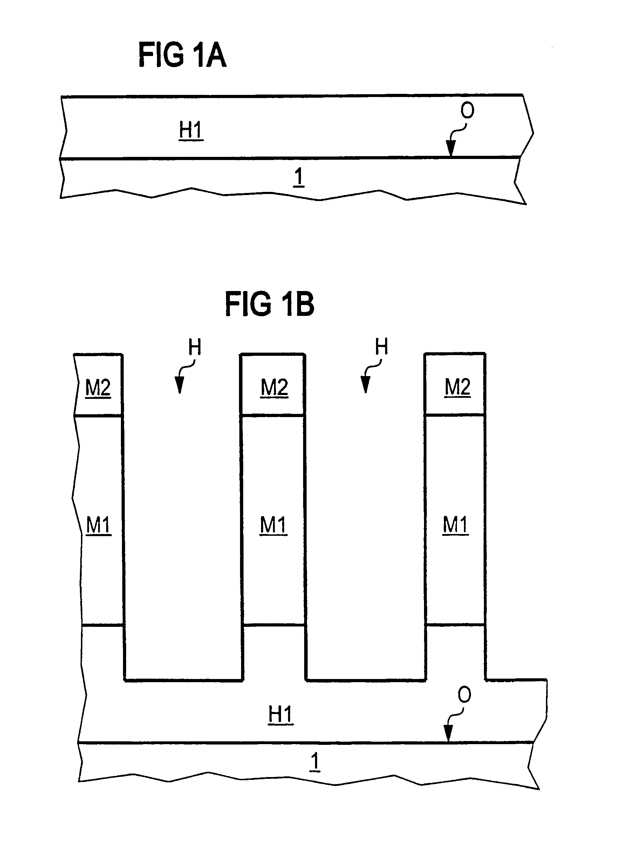

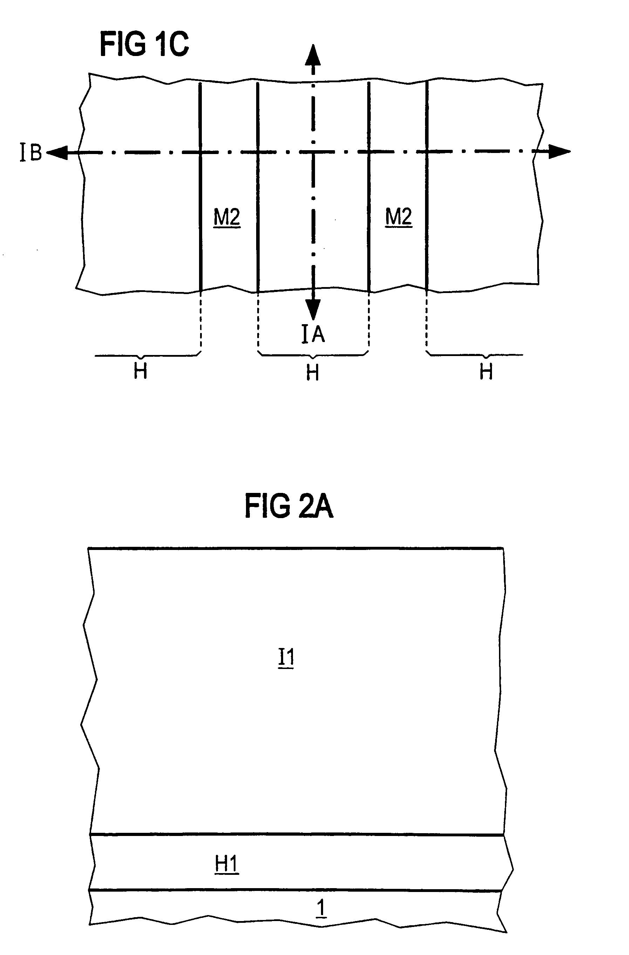

Anschließend wird eine erste Hilfsschicht H1 erzeugt, indem Siliziumnitrid in einer Dicke von ca. 400 nm abgeschieden wird (siehe Figuren 1a und 1b).

Zur Erzeugung einer ersten Maskenschicht M1 wird BPSG (Borphosphorsilikatglas) in einer Dicke von ca. 800 nm abgeschieden (siehe Figur 1b).

Zur Erzeugung einer zweiten Maskenschicht M2 wird Siliziumnitrid in einer Dicke von ca. 200 nm abgeschieden (siehe Figur 1b).

Mit Hilfe einer ersten Photolackmaske (nicht dargestellt) werden die erste Maskenschicht M1 und die zweite Maskenschicht M2 streifenförmig strukturiert und in der ersten Hilfsschicht H1 Hilfsgräben H erzeugt (siehe Figuren 1b und 1c). Die Hilfsgräben sind ca. 300 nm breit und weisen einen Abstand von ca. 150 nm voneinander auf. Die zweite Maskenschicht M2 und die erste Hilfsschicht H1 werden mit zum Beispiel C₂F₆ + O₂ geätzt. Die erste Maskenschicht M1 wird zum Beispiel mit CHF₃ + O₂ geätzt. Anschließend wird die erste Photolackmaske entfernt.

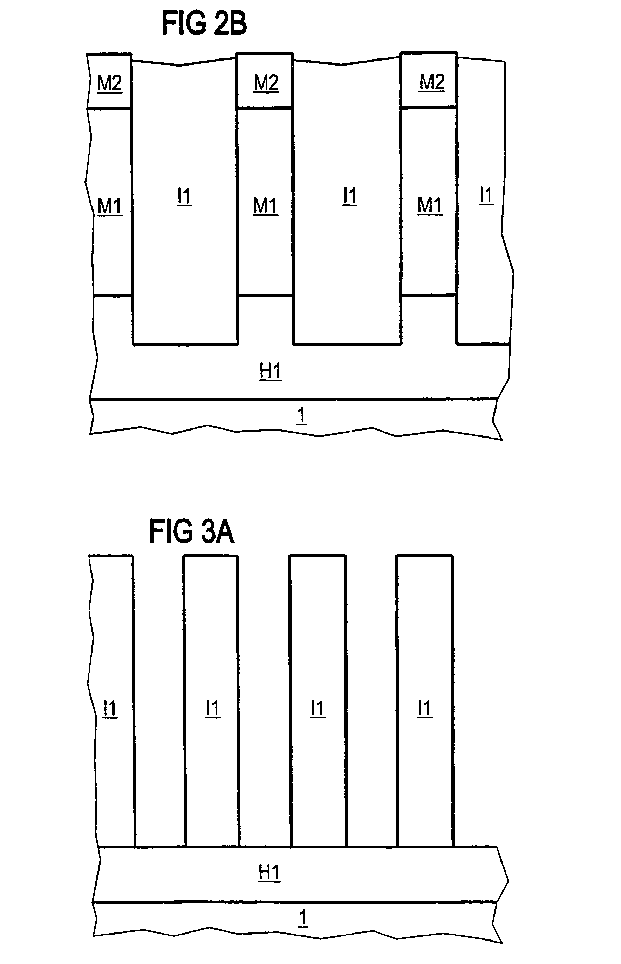

In den Hilfsgräben H und zwischen den Teilen der strukturierten ersten Maskenschicht M1 und der strukturierten zweiten Maskenschicht M2 werden erste isolierende Strukturen I1 erzeugt, indem SiO₂ in einer Dicke von ca. 300 nm abgeschieden und mit zum Beispiel CHF₂ + O₂ rückgeätzt wird, bis die zweite Maskenschicht M2 freigelegt wird (siehe Figuren 2a und 2b).

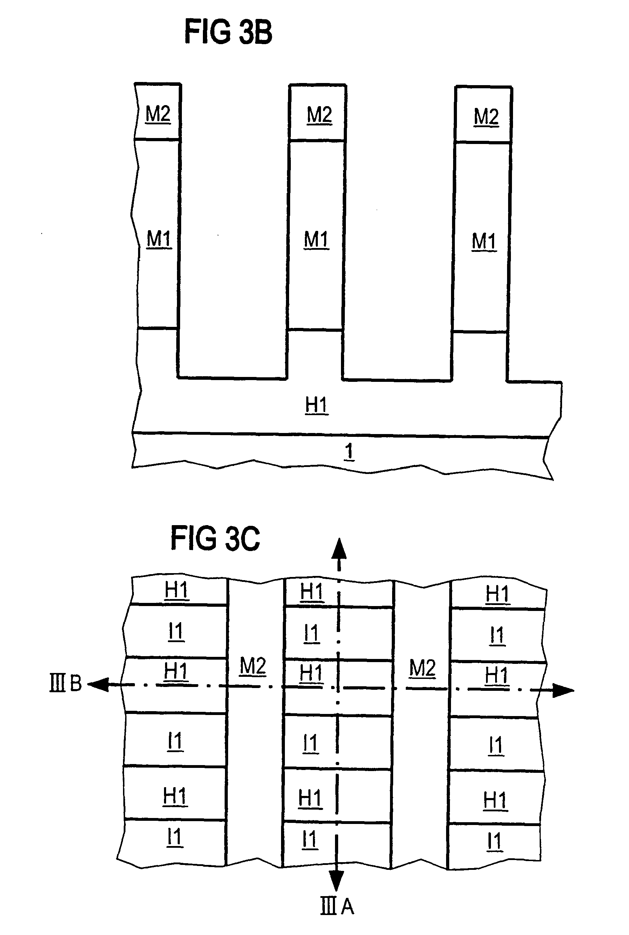

Mit Hilfe einer streifenförmigen zweiten Photolackmaske (nicht dargestellt), deren Streifen quer zu den Hilfsgräben H verlaufen, eine Breite von ca. 150 nm und einen Abstand von ca. 150 nm voneinander aufweisen, wird SiO₂ mit zum Beispiel CHF₃O₂ selektiv zu Siliziumnitrid entfernt. Dadurch werden Teile der Böden der Hilfsgräben H freigelegt (siehe Figuren 3a, 3b und 3c). Neben der zweiten Photolackmaske wirkt dabei die zweite Maskenschicht M2 als Maske. Die zweite Photolackmaske wird entfernt.

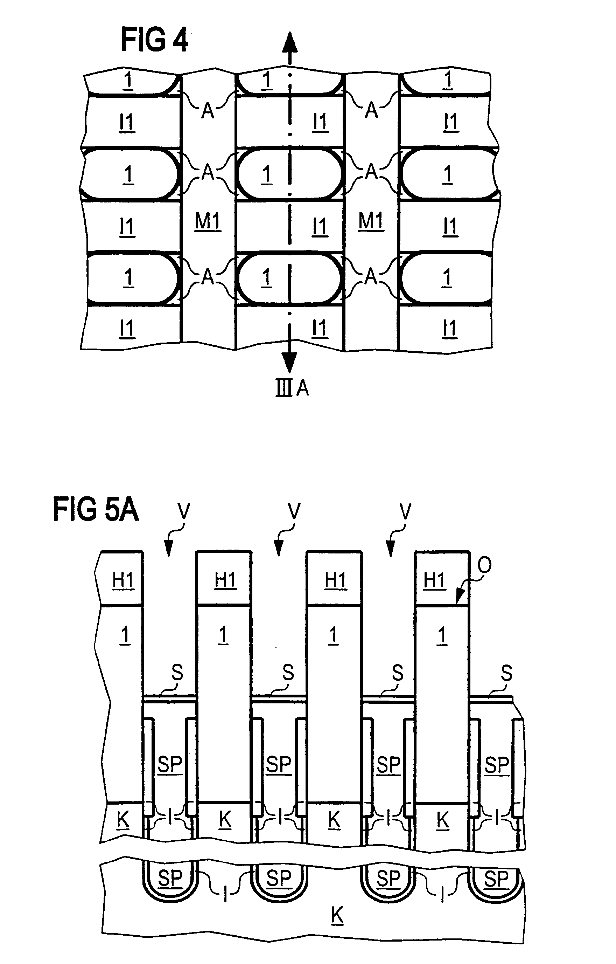

Anschließend werden Abrundungselemente A erzeugt, indem SiO₂ in einer Dicke von ca. 60 nm abgeschieden und rückgeätzt wird, bis die zweite Maskenschicht M2 freigelegt wird. Anschließend wird SiO₂ isotrop mit zum Beispiel HF ca. 60 nm tief geätzt, so daß aus übrigbleibenden Teilen des abgeschiedenen SiO₂ in Kanten, die durch die erste Maskenschicht M1, bzw. die zweite Maskenschicht M2 und den ersten isolierenden Strukturen I1 gebildet werden, die Abrundungselemente A erzeugt werden (siehe Figur 4).

Anschließend wird Siliziumnitrid selektiv zu SiO₂ geätzt, bis das Substrat 1 teilweise freigelegt wird. Dabei wird die erste Hilfsschicht H1 im Bereich der Hilfsgräben H teilweise entfernt, und die zweite Maskenschicht M2 entfernt.

In den freiliegenden Teilen des Substrats 1 werden ca. 10 µm tiefe Vertiefungen V erzeugt. Als Ätzmittel ist zum Beispiel HBr + HS geeignet. Hierbei wird selektiv zu SiO₂ geätzt (siehe Figuren 5a und 5b). Die erste Maskenschicht M1, die ersten isolierenden Strukturen I1 und die Abrundungselemente A wirken also als Maske.

Aufgrund der Abrundungselemente A weisen Flanken der Vertiefungen V keine Kanten auf. In Richtung der Streifen der zweiten Photolackmaske verlaufen ebene Abschnitte der Flanken der Vertiefungen V.

Anschließend wird SiO₂ mit zum Beispiel CHF₃ + O₂ geätzt, bis die erste Maskenschicht M1, die ersten isolierenden Strukturen 11 und die Abrundungselemente A entfernt werden.

Zur Erzeugung einer für Kondensatoren gemeinsamen Kondensatorelektrode K wird Arsenglas in einer Dicke von ca. 20 nm abgeschieden. Darüber wird PMMA (Polymethylmethacrylat) in einer Dicke von ca. 500 nm abgeschieden und ca. 1,5 µm tief mit zum Beispiel O₂ zurückgeätzt. Abschließend werden freiliegende Teile des Arsenglases mit zum Beispiel HF entfernt. Durch einen Temperschritt diffundiert Arsen aus dem Arsenglas in das Substrat 1, so daß die Kondensatorelektrode K als zusammenhängendes dotiertes Gebiet im Substrat 1 erzeugt wird (siehe Figuren 5a und 5b).

Zur Erzeugung von ersten Teilen von Isolationen I wird Siliziumnitrid in einer Dicke von ca. 3 nm aufgewachsen und durch thermische Oxidation ca. 1 nm tief aufoxidiert. Anschließend wird in situ n-dotiertes Polysilizium in einer Dicke von ca. 300 nm abgeschieden und ausgehend von der Oberfläche O ca. 2 µm tief rückgeätzt. Freiliegende Teile der ersten Teile der Isolationen I werden mit zum Beispiel HF entfernt.

Zweite Teile der Isolationen I werden erzeugt, indem SiO₂ in einer Dicke von ca. 20 nm abgeschieden und rückgeätzt wird, bis das Polysilizium freigelegt wird (siehe Figuren 5a und 5b). Die zweiten Teile der Isolationen I sind oberhalb der Kondensatorelektrode K angeordnet und im Vergleich zu den ersten Teilen der Isolationen I besonders dick ausgestaltet.

Anschließend wird in situ n-dotiertes Polysilizium in einer Dicke von ca. 300 nm abgeschieden, durch chemisch mechanisches Polieren planarisiert, bis die erste Hilfsschicht H1 freigelegt wird und ca. 800 nm tief rückgeätzt.

Anschließend wird SiO₂ isotrop mit zum Beispiel HF ca. 60 nm tief geätzt, so daß die Isolationen I weiter verkürzt werden. Die hierbei entfernten Teile der Isolationen I werden durch amorphes Silizium ersetzt, indem das amorphe Silizium in einer Dicke von ca. 20 nm abgeschieden und ca. 30 nm weit isotrop mit zum Beispiel C₂F₆ + O₂ rückgeätzt wird. Aus dem n-dotierten Polysilizium und dem amorphen Silizium entstehen Speicherknoten SP der Kondensatoren. Oberhalb der zweiten Teile der Isolationen I grenzen die Speicherknoten SP direkt an das Substrat 1 an (siehe Figuren 5a und 5b).

Auf den Speicherknoten SP wird eine ca. 40 nm dicke isolierende Schicht S durch ein HDP (High-density-plasma)-Verfahren erzeugt, indem SiO₂ abgeschieden und zugleich im wesentlichen isotrop geätzt wird, wobei an horizontalen Flächen mehr abgeschieden wird als an seitlichen Flächen (siehe Figuren 5a und 5b).

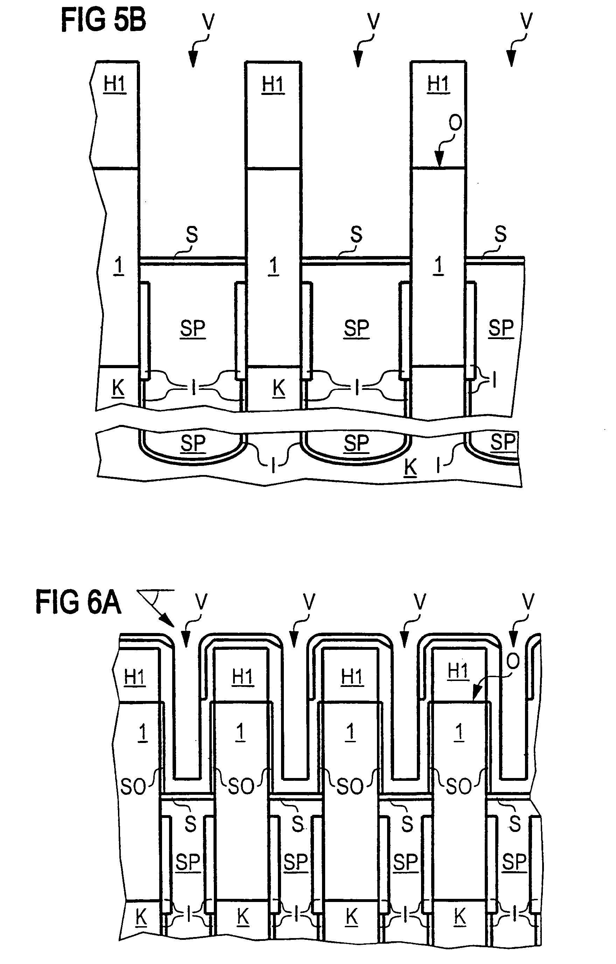

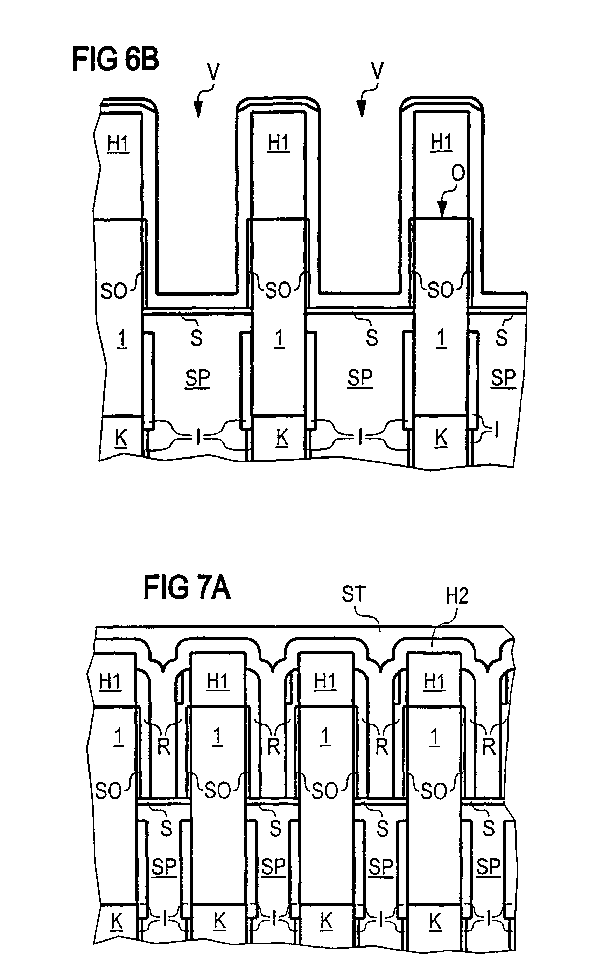

Zur Erzeugung eines Schutzoxids SO wird SiO₂ in einer Dicke von 5 nm abgeschieden (siehe Figuren 6a und 6b).

Anschließend wird amorphes Silizium in einer Dicke von ca. 40 nm abgeschieden (siehe Figuren 6a und 6b).

Durch schräge Implantation mit p-dotierenden Ionen werden Teile des amorphen Siliziums dotiert (siehe Figuren 6a und 6b). Die schräge Implantation erfolgt unter einem Winkel von ca. 30° zur Oberfläche O und in einem Winkel von 90° bezüglich des Verlaufs der Hilfsgräben H.

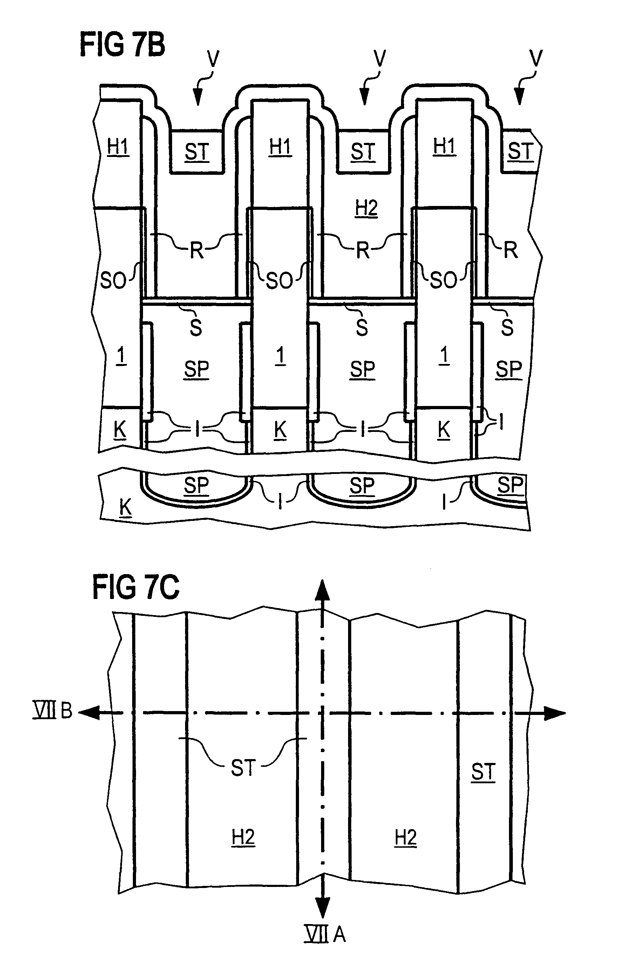

Zur Erzeugung von Spacern R wird das amorphe Silizium mit zum Beispiel C₂S₆ + O₂ ca. 90 nm weit ruckgeätzt, so daß die Spacer R bis ca. 50 nm unterhalb der angrenzenden Teile der ersten Hilfsschicht H1 reichen (siehe Figuren 7a und 7b). Erste Teile der Spacer R sind p-dotiert, während übrige Teile der Spacer R undotiert sind.

Zur Erzeugung einer zweiten Hilfsschicht H2 wird SiO₂ in einer Dicke von ca. 40 nm abgeschieden.

Anschließend wird amorphes Silizium in einer Dicke von ca. 200 nm abgeschieden, durch chemisch-mechanisches Polieren planarisiert, bis die zweite Hilfsschicht H2 erreicht wird und anschließend ca. 100 nm tief rückgeätzt, so daß amorphes Silizium nur noch in den Hilfsgräben H angeordnet ist und streifenförmige Strukturen ST bildet (siehe Figuren 7a, 7b und 7c).

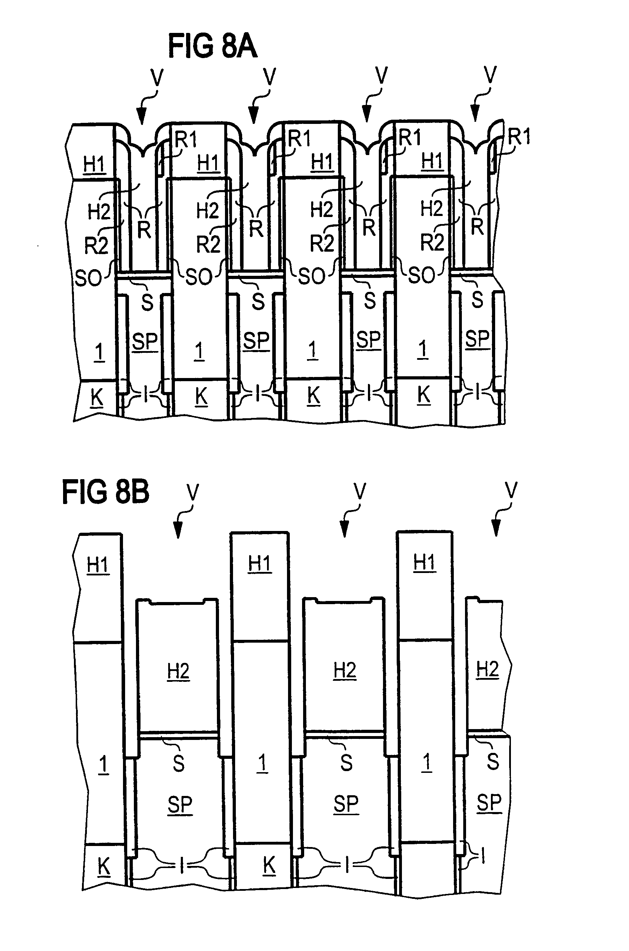

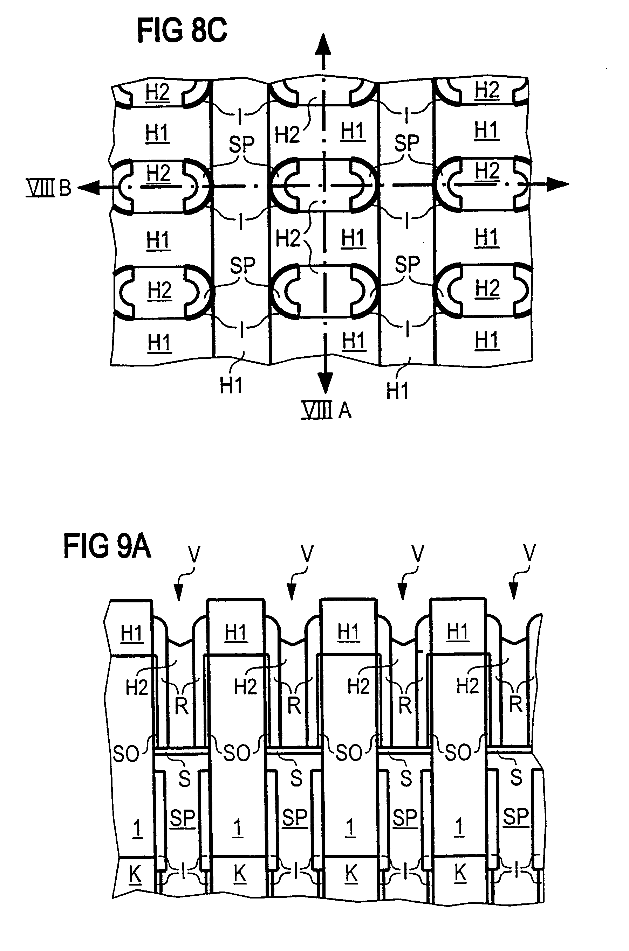

Anschließend wird SiO₂ ca. 300 nm weit selektiv zu Siliziumnitrid und Silizium geätzt, so daß freiliegende Teile der zweiten Hilfsschicht H2 entfernt werden. Dadurch werden Teile der Spacer R, die im Bereich von Flanken der Hilfsgräben H angeordnet sind, freigelegt. Durch Ätzen von Silizium selektiv zu SiO₂ werden diese Teile der Spacer R sowie die streifenförmigen Strukturen ST entfernt, bis die isolierende Schicht S teilweise freigelegt wird (siehe Figuren 8b und 8c). Dadurch werden die Spacer R aufgetrennt. Jeder der Spacer R umfaßt einen ersten Teil R1, der durch die schräge Implantation p-dotiert ist und einen zweiten Teil R2, der elektrisch aufgrund der Auftrennung vom ersten Teil R1 getrennt ist und dem ersten Teil R1 gegenüberliegt.

Anschließend werden die freigelegten Teile der isolierenden Schicht S entfernt. Dabei werden freiliegende Teile des Schutzoxids SO entfernt. Freiliegende Teile der Speicherknoten SP werden ca. 50 nm tief geätzt.

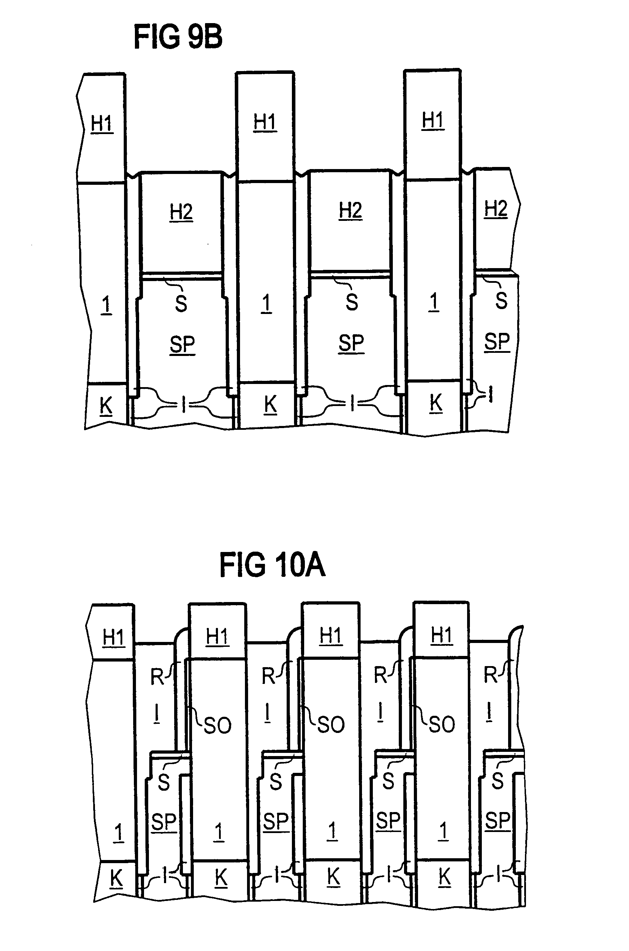

Die entfernten Teile der Speicherknoten SP werden durch isolierendes Material ersetzt, indem SiO₂ in einer Dicke von ca. 50 nm abgeschieden wird (siehe Figur 9b). Die Isolationen I werden dadurch vergrößert.

Anschließend wird ein Temperschritt durchgeführt, bei dem Dotierstoff aus den ersten Teilen der Spacer R1 in angrenzenden Teilen der Spacer R diffundiert und im wesentlichen homogen verteilt wird (siehe Figur 9a). Dabei wird das amorphe Silizium in Polysilizium umgewandelt.

Anschließend wird SiO₂ isotrop mit zum Beispiel HF ca. 100 nm weit geätzt.

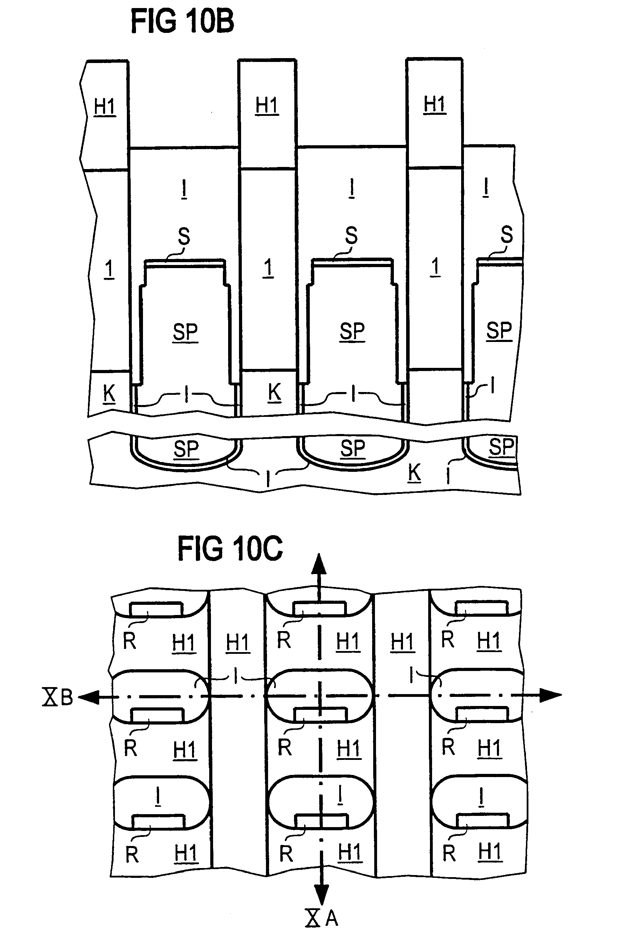

Anschließend werden die aufgetrennten Spacer R strukturiert, indem undotiertes Polysilizium selektiv zu p-dotiertem Polysilizium geätzt wird. Als Ätzmittel ist zum Beispiel Cholin geeignet. Dadurch werden die zweiten Teile der Spacer R2 entfernt und Teile der isolierenden Schicht S freigelegt (siehe Figuren 10a, 10b und 10c).

Die freigelegten Teile der isolierenden Schicht S werden entfernt, so daß erste Teile der Speicherknoten SP freigelegt werden. Dabei werden auch freiliegende Teile des Schutzoxids SO entfernt. Die ersten Teile der Speicherknoten SP werden anschließend entfernt, indem Polysilizium ca. 50 nm tief geätzt wird (siehe Figur 10a). Die Isolationen I werden verändert, indem SiO₂ in einer Dicke von ca. 300 nm abgeschieden, durch chemisch-mechanisches Polieren planarisiert wird, bis die erste Hilfsschicht H1 freigelegt wird, und anschließend ca. 350 nm tief rückgeätzt wird. Nur noch zweite Teile der Speicherknoten SP, die unterhalb der ersten Teile der Spacer R1 angeordnet sind, grenzen an das Substrat 1 an (siehe Figuren 10a und 10b).

Da die zweite Hilfsschicht H2 aus dem selben Material wie die Isolationen I besteht, ist es zweckmäßig, wenn im folgenden die zweite Hilfsschicht H2 als Teil der Isolationen I gilt.

Anschließend werden die ersten Teile der Spacer R1 sowie die damit verbundenen Teile der Spacer R entfernt, indem Polysilizium selektiv zu SiO₂ geätzt wird, bis Teile der isolierenden Schicht S freigelegt werden.

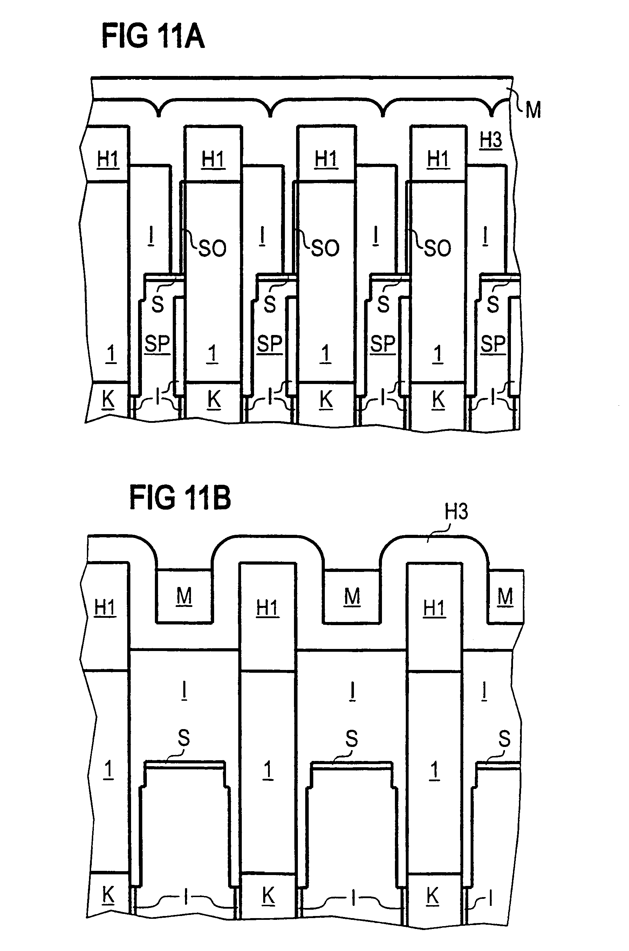

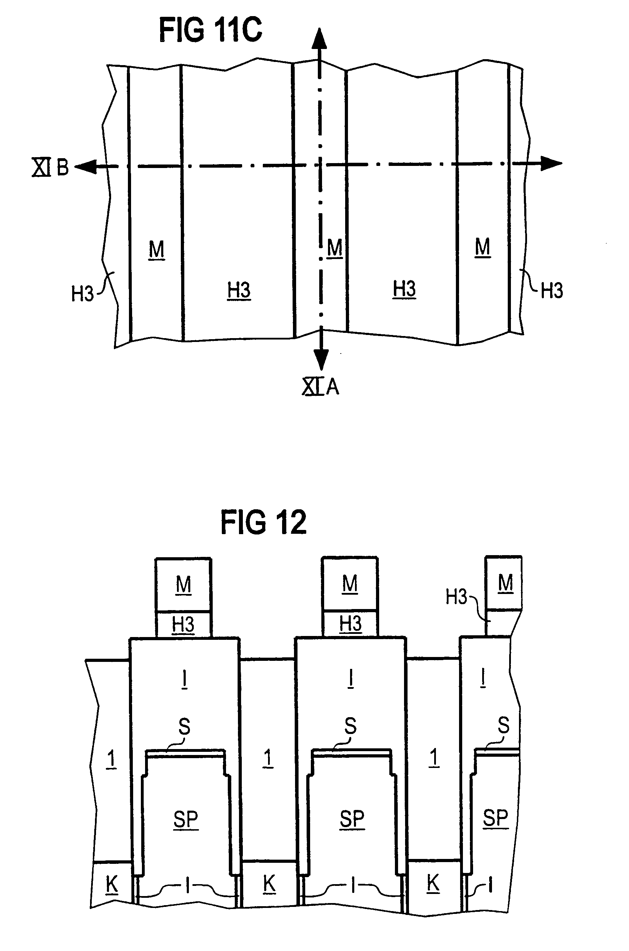

Zur Erzeugung einer dritten Hilfsschicht H3 wird Siliziumnitrid in einer Dicke von ca. 80 nm abgeschieden (siehe Figuren 11a, 11b und 11c). Anschließend wird SiO₂ in einer Dicke von ca. 300 nm abgeschieden und durch chemisch-mechanisches Polieren planarisiert, bis die erste Hilfsschicht H1 freigelegt wird, und anschließend 100 nm rückgeätzt, so daß aus dem SiO₂ eine streifenförmige Maske M gebildet wird. In den Hilfsgräben H ist jeweils ein Streifen der Maske M angeordnet (siehe Figuren 11a, 11b und 11c).

Freiliegende Teile der dritten Hilfsschicht H3 werden selektiv zur Maske M entfernt (siehe Figur 12). Dabei werden auch Teile der ersten Hilfsschicht H1, die außerhalb der Maske M angeordnet sind, entfernt, so daß darunter angeordnete Teile des Substrats 1 freigelegt werden (siehe Figur 12).

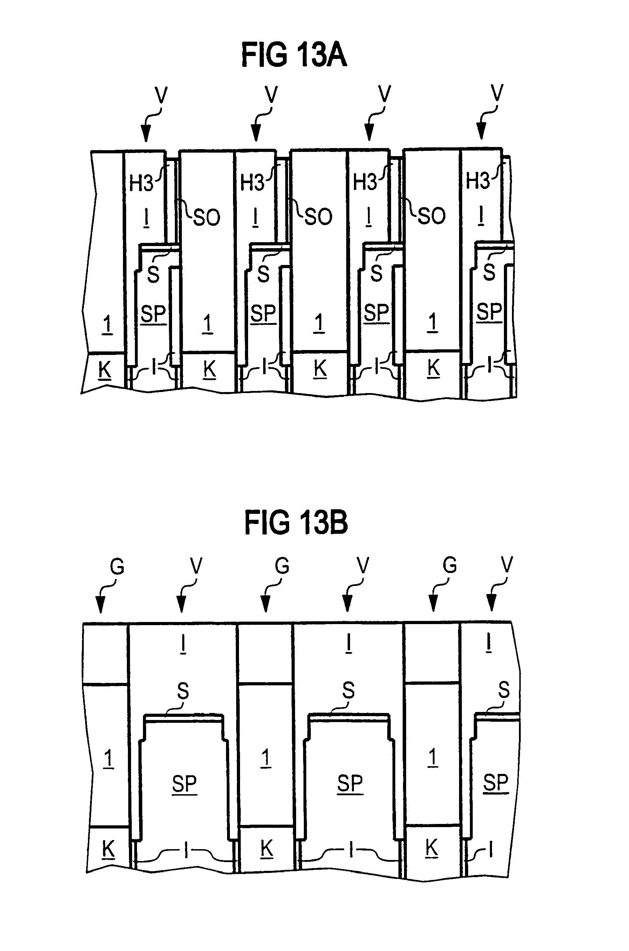

Zur Erzeugung von Isolationsgräben G wird Silizium selektiv zu SiO₂ ca. 200 nm tief mit zum Beispiel HBr und HF geätzt (siehe Figur 13b). Anschließend wird SiO₂ in einer Dicke von ca. 300 nm abgeschieden, durch chemisch-mechanisches Polieren planarisiert, bis die dritte Hilfsschicht H3 freigelegt wird. Dabei wird die Maske M entfernt. SiO₂ wird anschließend ca. 300 nm tief rückgeätzt.

Anschließend wird Siliziumnitrid ca. 500 nm tief rückgeätzt, so daß außerhalb der Vertiefungen V angeordnete Teile der dritten Hilfsschicht H3 entfernt werden und die erste Hilfsschicht H1 entfernt werden (siehe Figuren 13a und 13b).

Anschließend wird SiO₂ durch chemisch mechanisches Polieren planarisiert, bis das Substrat 1 freigelegt wird (siehe Figuren 13a und 13b).

Durch Implantation mit n-dotierenden Ionen werden in den freigelegten Teil des Substrats 1 ca. 50nm tiefe zweite Source-/Drain-Gebiete S/D2 von Transistoren erzeugt. Durch Implantation mit p-dotierenden Ionen wird unter den zweiten Source/Drain-Gebieten S/D2 die Dotierstoffkonzentration auf 6*10¹⁷cm⁻³ erhöht.

Die dritte Hilfsschicht H3 und das Schutzoxid SO werden entfernt.

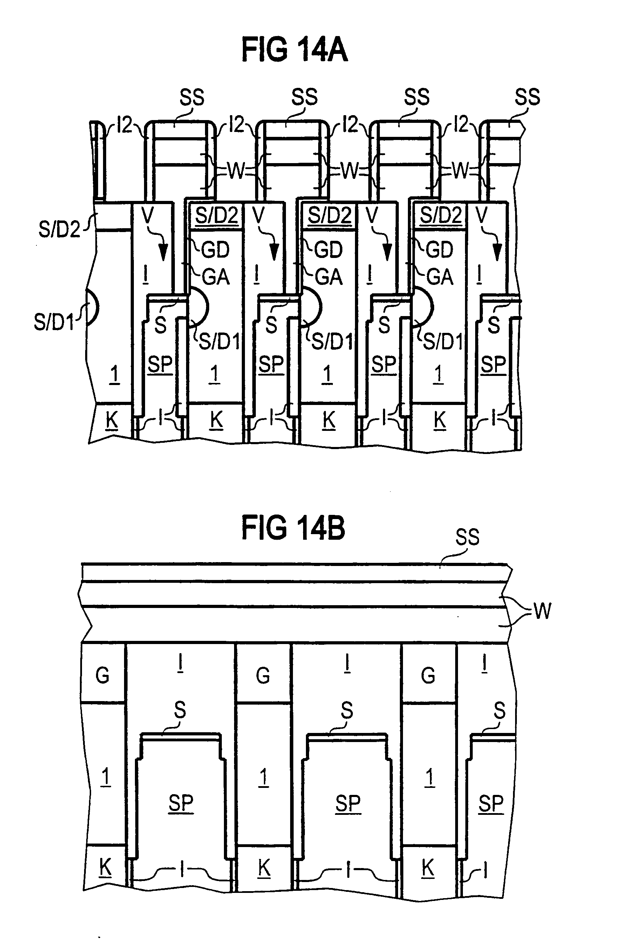

Durch einen Temperschritt wird an freigelegten Teilen der Flanken der Vertiefungen V ein ca. 4 nm dickes Gatedielektrikum GD erzeugt (siehe Figuren 14a und 14b). Beim Temperschritt diffundiert Dotierstoff aus den Speicherknoten SP in das Substrat 1 und bildet dort erste Source-/Drain-Gebiete S/D1 der Transistoren. Ferner diffundiert der Dotierstoff der zweiten Source-/Drain-Gebiete S/D2 derart, daß die zweiten Source-/Drain-Gebiete S/D2 ca. 100 nm dick werden und eine Dotierstoffkonzentration von ca. 10²⁰ cm⁻³ aufweisen.

Zur Erzeugung von Gateelektroden GA und Wortleitungen W wird insitu n-dotiertes Polysilizium in einer Dicke von ca. 100 nm abgeschieden. Darüber wird Wolframsilizid in einer Dicke von ca. 50 nm abgeschieden. Zur Erzeugung einer Schutzschicht SS wird Siliziumnitrid in einer Dicke von ca. 100 nm abgeschieden (siehe Figuren 14a und 14b).

Mit Hilfe einer streifenförmigen dritten Photolackmaske (nicht dargestellt), die der zweiten Photolackmaske entspricht jedoch derart versetzt zur zweiten Photolackmaske angeordnet ist, daß sie die Vertiefungen V nur teilweise bedeckt, wird die Schutzschicht SS strukturiert. Anschließend wird die dritte Photolackmaske entfernt. Mit Hilfe der Schutzschicht SS als Maske werden das Wolframsilizid und Polysilizium geätzt, bis das Gatedielektrikum GD über den zweiten Source-/Drain-Gebieten S/D2 freigelegt wird. Aus dem Polysilizium in den Vertiefungen V, das die zweiten Teile der Spacer R ersetzt, werden die Gateelektroden GA gebildet. Aus darüber angeordnetem Polysilizium und Wolframsilizid entstehen Wortleitungen W, die quer zu den Hilfsgräben H verlaufen (siehe Figuren 14a, 14b und 14c).

Zur Erzeugung von spacerförmigen zweiten isolierenden Strukturen I2 wird Siliziumnitrid in einer Dicke von ca. 300 nm abgeschieden und rückgeätzt. Die Schutzschicht SS und die zweiten isolierenden Strukturen I2 umgeben die Wortleitungen W (siehe Figuren 14a und 14b).

Zur Erzeugung eines Zwischenoxids Z wird SiO₂ in einer Dicke von ca. 400 nm abgeschieden.

Mit Hilfe einer vierten Photolackmaske (nicht dargestellt) werden Kontaktlöcher zu den zweiten Source-/Drain-Gebieten S/D2 geöffnet, wobei SiO₂ selektiv zu Siliziumnitrid geätzt wird, so daß die Schutzschicht SS und die zweiten isolierenden Strukturen I2 die Wortleitungen W schützen.

Zur Erzeugung von Kontakten KO in den Kontaktlöchern wird insitu dotiertes Polysilizium in einer Dicke von ca. 100 nm abgeschieden und durch chemisch-mechanisches Polieren planarisiert, bis das Zwischenoxid Z freigelegt wird.

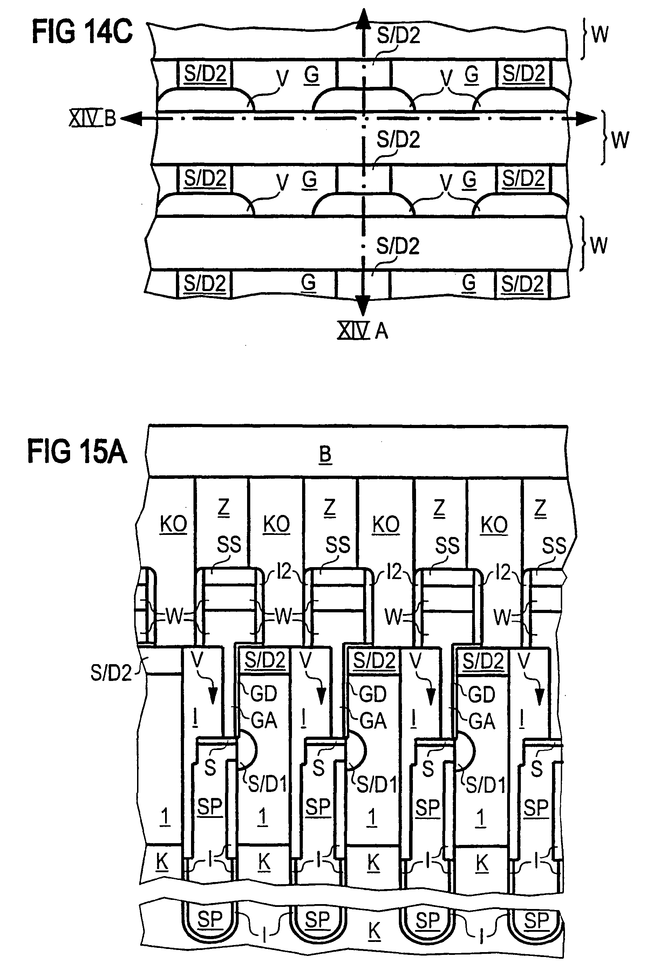

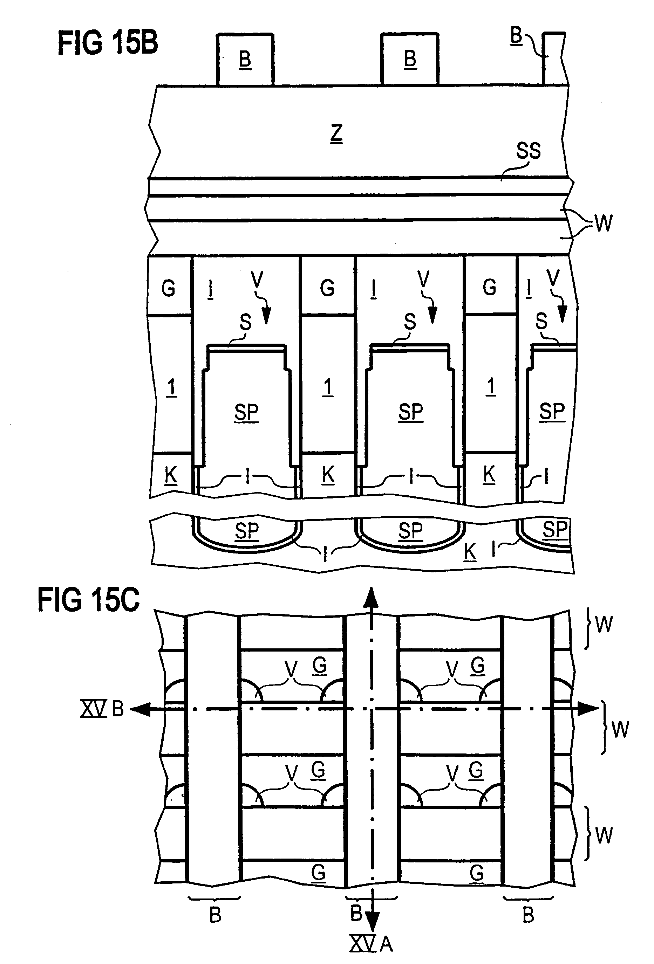

Zur Erzeugung von Bitleitungen B wird Wolframsilizid in einer Dicke von ca. 200 nm abgeschieden und mit Hilfe einer fünften streifenförmigen Photolackmaske, die der ersten Photolackmaske entspricht, strukturiert (siehe Figuren 15a, 15b und 15c).

Eine Speicherzelle der erzeugten DRAM-Zellenanordnung umfaßt einen der Kondensatoren und einen der damit verbundenen Transistoren. Die Transistoren sind als vertikale Transistoren ausgebildet, bei denen ein Kanalstrom in vertikaler Richtung ausgebildet wird. Zwischen den ersten Source-/Drain-Gebieten und den zweiten Source-/Drain-Gebieten angeordnete Teile des Substrats wirken als Kanalgebiete der Transistoren. Die Kanalgebiete der Transistoren sind elektrisch miteinander verbunden, so daß Floating-Body-Effekte vermieden werden.

Es sind viele Variationen des Ausführungsbeispiels denkbar, die ebenfalls im Rahmen der Erfindung liegen. Insbesondere können Abmessungen der beschriebenen Schichten, Masken, Vertiefungen und Strukturen an die jeweiligen Erfordernisse angepaßt werden.

Die Implantation zur unterschiedlichen Dotierung der ersten Teile und der zweiten Teile der Spacer kann auch nach Erzeugung der Spacer erfolgen.

Damit die Hilfsgräben eine besonders genau definierte Tiefe erhalten, liegt es im Rahmen der Erfindung, innerhalb der ersten Hilfsschicht eine Ätzstopschicht vorzusehen, die als Ätzstop bei der Erzeugung der Hilfsgräben wirkt. Die Ätzstopschicht besteht beispielsweise aus SiO₂.

## Patentansprüche

1. Verfahren zur Herstellung einer DRAM-Zellenanordnung,
- bei dem in einem Substrat (1) jeweils für einen Kondensator einer Speicherzelle der DRAM-Zellenanordnung eine Vertiefung (V) erzeugt wird,
- bei dem in der Vertiefung (V) eine Isolation (I) und ein Speicherknoten (SP) des Kondensators, der mindestens teilweise durch die Isolation (I) vom Substrat (1) getrennt wird, erzeugt werden,
- bei dem durch Silizium Abscheiden, Rückätzen und schräge Implantation von Dotierstoff uber dem Speicherknoten (SP) in der Vertiefung (V) entlang Flanken der Vertiefung (V) ein Spacer (R) aus Silizium erzeugt wird, bei dem ein erster Teil des Spacers (R1) und ein zweiter, dem ersten Teil gegenüberliegender Teil des Spacers (R2) unterschiedlich dotiert sind,
- bei dem der Spacer (R) strukturiert wird, indem entweder der erste Teil des Spacers (R1) oder der zweite Teil des Spacers (R2) unter Ausnutzung ihrer unterschiedlichen Dotierung entfernt wird,
- bei dem ein unter dem entfernten Teil des Spacers (R2) angeordneter erster Teil des Speicherknotens (SP) und die Isolation (I) derart verändert werden, daß entweder der erste Teil des Speicherknotens (SP) oder ein unter dem verbleibenden Teil des Spacers (R1) angeordneter zweiter Teil des Speicherknotens (SP) an das Substrat (1) angrenzt, wobei der strukturierte Spacer (R) als Maske dient,
- bei dem ein Transistor der Speicherzelle so erzeugt wird, daß ein erstes Source/Drain-Gebiet (S/D1) im Substrat (1) angrenzend an den Speicherknoten (SP) gebildet wird,
- bei dem eine Wortleitung (W) erzeugt und mit einer Gateelektrode (GA) des Transistors verbunden wird,
- bei dem eine Bitleitung (B), die quer zur Wortleitung (W) verläuft, erzeugt und mit der Speicherzelle verbunden wird.

2. Verfahren nach Anspruch 1,
- bei dem der Speicherknoten (SP) und die Isolation (I) zunächst so erzeugt werden, daß sowohl der erste Teil des Speicherknotens (SP) als auch der zweite Teil des Speicherknotens (SP) an das Substrat (1) angrenzen,
- bei dem unter Verwendung des strukturierten Spacers (R) als Maske der erste Teil des Speicherknotens (SP) entfernt wird,
- bei dem die Isolation (I) derart vergrößert wird, daß sie den ersten Teil des Speicherknotens (SP) ersetzt.

3. Verfahren nach Anspruch 1 oder 2,
- bei dem auf dem Speicherknoten (SP) eine isolierende Schicht (S) erzeugt wird,
- bei dem der Spacer (R) auf der isolierenden Schicht (S) erzeugt wird,
- bei dem nach Strukturierung des Spacers (R) ein freiliegender Teil der isolierenden Schicht (S) entfernt wird,
- bei dem der verbleibende Teil des Spacers (R1) nach Fertigstellung des Speicherknotens (SP) zumindest teilweise durch die Gateelektrode (GA) ersetzt wird,
- bei dem ein zweites Source/Drain-Gebiet (S/D2) des Transistors oberhalb des ersten Source/Drain-Gebiets (S/D1) des Transistors erzeugt wird, so daß der Transistor als vertikaler Transistor gebildet wird.

4. Verfahren nach einem der Ansprüche 1 bis 3,
- bei dem die Implantation in das Silizium derart ist, daß der erste Teil des Spacers n-dotiert ist,
- bei dem vor Strukturierung des Spacers eine thermische Oxidation durchgeführt wird,
- bei dem das gebildete Oxid geätzt wird, bis der zweite Teil des Spacers freigelegt wird,
- bei dem beim Strukturieren des Spacers Silizium selektiv zum Oxid geätzt wird, so daß der zweite Teil des Spacers entfernt wird.

5. Verfahren nach einem der Ansprüche 1 bis 3,
- bei dem beim Strukturieren des Spacers (R) der erste Teil des Spacers (R1) selektiv zum zweiten Teil des Spacers (R2) weggeätzt wird oder umgekehrt.

6. Verfahren nach einem der Ansprüche 2 bis 5,
- bei dem auf dem Substrat (1) eine erste Hilfsschicht (H1) erzeugt wird,
- bei dem in der ersten Hilfsschicht (H1) im wesentlichen parallel zueinander verlaufende, nebeneinander angeordnete Hilfsgräben (H) erzeugt werden, die die erste Hilfsschicht (H1) nicht durchtrennen,
- bei dem die Vertiefungen (V) für Kondensatoren auch in den Hilfsgräben (H) erzeugt werden,
- bei dem nach Erzeugung des Spacers (R) eine zweite Hilfsschicht (H2) aus einem ersten Material, das selektiv zu Silizium ätzbar ist, im wesentlichen konform abgeschieden wird, wobei die zweite Hilfsschicht (H2) so dünn ist, daß die Hilfsgräben (H) nicht aufgefüllt werden,
- bei dem ein zweites Material, das selektiv zum ersten Material ätzbar ist, abgeschieden und rückgeätzt wird, bis das zweite Material als streifenförmige Strukturen (ST) nur noch innerhalb der Hilfsgräben (H) vorhanden ist,
- bei dem freigelegte Teile der zweiten Hilfsschicht (H2) selektiv zu den streifenförmigen Strukturen (ST) entfernt werden bis Teile des Spacersfreigelegt sind,
- bei dem Silizium geätzt wird, bis der Spacer (R) aufgetrennt wird, so daß der erste Teil des Spacers (R1) vom zweiten Teil des Spacers (R2) elektrisch getrennt wird,
- bei dem unter Verwendung der zweiten Hilfsschicht (H2) und der ersten Hilfsschicht (H1) als Maske Teile des Speicherknotens (SP) entfernt und durch isolierendes Material ersetzt werden, so daß der Speicherknoten (SP) nur mit seinem ersten Teil und mit seinem zweiten Teil an das Substrat (1) angrenzt,
- bei dem der aufgetrennte Spacer (R) strukturiert wird.

7. Verfahren nach Anspruch 6,
- bei dem nach Auftrennung des Spacers (R) der im ersten Teil des Spacers (R1) implantierte Dotierstoff bei einem Temperschritt diffundiert.

8. Verfahren nach einem der Ansprüche 6 bis 7,
- bei dem nach Veränderung der Isolation (I) und des Speicherknotens (SP) isolierendes Material abgeschieden und rückgeätzt wird, bis der verbleibende Teil des Spacers (R1) freigelegt wird,
- bei dem der verbleibende Teil des Spacers (R1) entfernt wird,
- bei dem eine dritte Hilfsschicht (H3) in einer solchen Dikke abgeschieden wird, daß die Hilfsgräben (H) nicht aufgefüllt werden,
- bei dem ein drittes Material abgeschieden und rückgeätzt wird, bis das dritte Material nur noch innerhalb der Hilfsgräben (H) vorhanden ist und in den Hilfsgräben (H) jeweils eine streifenförmige Maske (M) bildet,
- bei dem freiliegende Teile der dritten Hilfsschicht (H3) selektiv zur Maske (M) entfernt werden,
- bei dem Teile der ersten Hilfsschicht (H1), die außerhalb der Maske (M) angeordnet sind, entfernt werden und darunter angeordnete Teile des Substrats (1) freigelegt werden,
- bei dem das Substrat (1) selektiv zur Maske (M) geätzt wird, so daß Isolationsgräben (G) erzeugt werden,
- bei dem die Maske (M) und erste Hilfsschicht (H1) entfernt werden,
- bei dem in ehemals unter der Maske (M) angeordneten Teilen des Substrats (1) die zweiten Source/Drain-Gebiete (S/D2) erzeugt werden,
- bei dem die Isolationsgräben (G) so erzeugt werden, daß sie tiefer als die zweiten Source/Drain-Gebiete (S/D2) sind.

9. Verfahren nach Anspruch 8,
- bei dem die Dicke der dritten Hilfsschicht (H3) gleich der Summe aus der Dicke des Spacers (R) und der Dicke der zweiten Hilfsschicht (H2) ist.

10. Verfahren nach einem der Ansprüche 1 bis 9,
- bei dem nach Fertigstellung des Speicherknotens (SP) Dotierstoff bei einem Temperschritt aus dem Speicherknoten (SP) in das Substrat (1) diffundiert und dort das erste Source/Drain-Gebiet (S/D1) bildet.

## Claims

1. Method for fabricating a DRAM cell arrangement,
- in which a depression (V) is produced in a substrate (1) in each case for a capacitor of a memory cell of the DRAM cell arrangement,
- in which an insulation (I) and a storage node (SP) of the capacitor, which is at least partly isolated from the substrate (1) by the insulation (I), are produced in the depression (v),
- in which, by silicon deposition, etching back and inclined implantation of dopant, a spacer (R) made of silicon is produced above the storage node (SP) in the depression (V) along sidewalls of the depression (V), in which a first part of the spacer (R1) and a second part - opposite to the first part - of the spacer (R2) are doped differently,
- in which the spacer (R) is patterned by either the first part of the spacer (R1) or the second part of the spacer (R2) being removed by utilizing their different doping,
- in which a first part of the storage node (SP) , said first part being arranged under the removed part of the spacer (R2), and the insulation (I) are altered in such a way that either the first part of the storage node (SP) or a second part of the storage node (SP), said second part being arranged under the remaining part of the spacer (R1), adjoins the substrate (1), the patterned spacer (R) serving as a mask,
- in which a transistor of the memory cell is produced in such a way that a first source/drain region (S/D1) is formed in the substrate (1) in a manner adjoining the storage node (SP),
- in which a word line (W) is produced and connected to a gate electrode (GA) of the transistor,
- in which a bit line (B) running transversely with respect to the word line (W) is produced and connected to the memory cell.

2. Method according to Claim 1,
- in which the storage node (SP) and the insulation (I) are firstly produced in such a way that both the first part of the storage node (SP) and the second part of the storage node (SP) adjoin the substrate (1),
- in which the first part of the storage node (SP) is removed using the patterned spacer (R) as a mask,
- in which the insulation (I) is enlarged in such a way that it replaces the first part of the storage node (SP).

3. Method according to Claim 1 or 2,
- in which an insulating layer (S) is produced on the storage node (SP),
- in which the spacer (R) is produced on the insulating layer (S),
- in which, after the patterning of the spacer (R), an uncovered part of the insulating layer (S) is removed,
- in which the remaining part of the spacer (R1) is at least partly replaced by the gate electrode (GA) after the completion of the storage node (SP),
- in which a second source/drain region (S/D2) of the transistor is produced above the first source/drain region (S/D1) of the transistor, with the result that the transistor is formed as a vertical transistor.

4. Method according to one of Claims 1 to 3,
- in which the implantation into the silicon is such that the first part of the spacer is n-doped,
- in which a thermal oxidation is carried out before the patterning of the spacer,
- in which the oxide formed is etched until the second part of the spacer is uncovered,
- in which, during the patterning of the spacer, silicon is etched selectively with respect to the oxide, with the result that the second part of the spacer is removed.

5. Method according to one of Claims 1 to 3,
- in which, during the patterning of the spacer (R), the first part of the spacer (R1) is etched away selectively with respect to the second part of the spacer (R2), or vice versa.

6. Method according to one of Claims 2 to 5,
- in which a first auxiliary layer (H1) is produced on the substrate (1),
- in which auxiliary trenches (H) which essentially run parallel to one another and are arranged next to one another are produced in the first auxiliary layer (H1), which auxiliary trenches do not cut through the first auxiliary layer (H1),
- in which the depressions (V) for capacitors are also produced in the auxiliary trenches (H),
- in which, after the production of the spacer (R), a second auxiliary layer (H2) made of a first material, which can be etched selectively with respect to silicon, is deposited essentially conformally, the second auxiliary layer (H2) being so thin that the auxiliary trenches (H) are not filled,
- in which a second material, which can be etched selectively with respect to the first material, is deposited and etched back until the second material is present as strip-type structures (ST) only within the auxiliary trenches (H),
- in which uncovered parts of the second auxiliary layer (H2) are removed selectively with respect to the strip-type structures (ST) until parts of the spacer are uncovered,
- in which silicon is etched until the spacer (R) is separated, with the result that the first part of the spacer (R1) is electrically isolated from the second part of the spacer (R2),
- in which, using the second auxiliary layer (H2) and the first auxiliary layer (H1) as a mask, parts of the storage node (SP) are removed and replaced by insulating material, with the result that only the first part and the second part of the storage node (SP) adjoin the substrate (1),
- in which the separated spacer (R) is patterned.

7. Method according to Claim 6,
- in which, after the separation of the spacer (R), the dopant implanted in the first part of the spacer (R1) diffuses during a heat-treatment step.

8. Method according to one of Claims 6 to 7,
- in which, after the alteration of the insulation (I) and of the storage node (SP), insulating material is deposited and etched back until the remaining part of the spacer (R1) is uncovered,
- in which the remaining part of the spacer (R1) is removed,
- in which a third auxiliary layer (H3) is deposited to a thickness such that the auxiliary trenches (H) are not filled,
- in which a third material is deposited and etched back until the third material is present only within the auxiliary trenches (H) and forms a respective strip-type mask (M) in the auxiliary trenches (H),
- in which uncovered parts of the third auxiliary layer (H3) are removed selectively with respect to the mask (M),
- in which parts of the first auxiliary layer (H1) which are arranged outside the mask (M) are removed and parts of the substrate (1) which are arranged underneath are uncovered,
- in which the substrate (1) is etched selectively with respect to the mask (M), with the result that isolation trenches (G) are produced,
- in which the mask (M) and first auxiliary layer (H1) are removed,
- in which the second source/drain regions (S/D2) are produced in parts of the substrate (1) which were formerly arranged under the mask (M),
- in which the isolation trenches (G) are produced in such a way that they are deeper than the second source/drain regions (S/D2).

9. Method according to Claim 8,
- in which the thickness of the third auxiliary layer (H3) is equal to the sum of the thickness of the spacer (R) and the thickness of the second auxiliary layer (H2).

10. Method according to one of Claims 1 to 9,
- in which, after the completion of the storage node (SP), dopant diffuses, during a heat-treatment step, from the storage node (SP) into the substrate (1) and forms the first source/drain region (S/D1) there.

## Revendications

1. Procédé de production d'un ensemble de cellules DRAM,
- dans lequel on produit dans un substrat (1) une cavité (V) respectivement pour un condensateur d'une cellule de mémoire de l'ensemble de cellules DRAM,
- dans lequel on produit dans la cavité (V) un isolement (I) et un noeud (SP) de mémoire du condensateur, qui est séparé du substrat (1) au moins en partie par l'isolement (I),
- dans lequel par dépôt de silicium, attaque latérale et implantation inclinée d'une substance de dopage au-dessus du noeud (SP) de mémoire dans la cavité (V), on produit le long des flancs de la cavité (V) un espaceur (R) en silicium, dans lequel une première partie de l'espaceur (R1) et une deuxième partie, opposée à la première partie, de l'espaceur (R2) sont dopées de façon différente,
- dans lequel on structure l'espaceur (R) en éliminant la première partie de l'espaceur (R1) ou la deuxième partie de l'espaceur (R2) en tirant parti de leurs dopages différents,
- dans lequel on modifie une première partie, disposée sous la partie éliminée de l'espaceur (R2), du noeud (SP) de mémoire et l'isolement (I) de façon à ce que la première partie du noeud (SP) de mémoire ou une deuxième partie, disposée sous la partie restante de l'espaceur (R1), du noeud (SP) de mémoire soit voisine du substrat (1), l'espaceur (R) structuré servant de masque,
- dans lequel on produit un transistor de la cellule de mémoire de façon à former une première zone (S/D1) de source/drain dans le substrat (1) voisine du noeud (SP) de mémoire,
- dans lequel on produit une ligne (W) de mot et on la relie à une électrode (GA) de grille du transistor,
- dans lequel on produit une ligne (B) de bit, qui s'étend transversalement à la ligne (W) de mot et qui est reliée à la cellule de mémoire.

2. Procédé suivant la revendication 1,
- dans lequel on produit d'abord le noeud (SP) de mémoire et l'isolement (I) de façon à ce que tant la première partie du noeud (SP) de mémoire qu'également la deuxième partie du noeud (SP) de mémoire soient voisines du substrat (1),
- dans lequel on élimine, en utilisant l'espaceur (R) structuré comme masque, la première partie du noeud (SP) de mémoire,
- dans lequel on agrandit l'isolement (I) de façon à ce qu'il remplace la première partie du noeud (SP) de mémoire.

3. Procédé suivant la revendication 1 ou 2,
- dans lequel on produit une couche (5) isolante sur le noeud (SP) de mémoire,
- dans lequel on produit l'espaceur (R) sur la couche (S) isolante,
- dans lequel après structuration de l'espaceur (R), on élimine une partie mise à nu de la couche (S) isolante,
- dans lequel on remplace la partie restante de l'espaceur (R1) après finition du noeud (SP) de mémoire au moins en partie par l'électrode (GA) de grille,
- dans lequel on produit une deuxième zone (S/D2) de source/drain du transistor au-dessus de la première zone (S/D1) de source/drain du transistor, de façon à former le transistor sous la forme d'un transistor vertical.

4. Procédé suivant l'une des revendications 1 à 3,
- dans lequel l'implantation dans le silicium est telle que la première partie de l'espaceur est à dopage du type n,
- dans lequel on effectue une oxydation thermique avant la structuration de l'espaceur,
- dans lequel on attaque l'oxyde formé jusqu'à mettre à nu la deuxième partie de l'espaceur,
- dans lequel on attaque, lors de la structuration de l'espaceur, du silicium sélectivement par rapport à l'oxyde de manière à éliminer la deuxième partie de l'espaceur.

5. Procédé suivant l'une des revendications 1 à 3,
- dans lequel on enlève par attaque, lors de la structuration de l'espaceur (8), la première partie de l'espaceur (R1) sélectivement par rapport à la deuxième partie de l'espaceur (R2) ou inversement.

6. Procédé suivant l'une des revendications 2 à 5,
- dans lequel on produit sur le substrat (1) une première couche (H1) auxiliaire,
- dans lequel on produit dans la première couche (H1) auxiliaire, des sillons (H) auxiliaires qui s'étendent en étant sensiblement parallèles les uns aux autres, qui sont disposés les uns à côté des autres et qui ne séparent pas la première couche (H1) auxiliaire,
- dans lequel on produit les cavités (V) pour des condensateurs également dans les sillons (H) auxiliaires,
- dans lequel on dépose de manière sensiblement conforme, après la production de l'espaceur (R), une deuxième couche (H2) auxiliaire en un premier matériau qui peut être attaqué sélectivement par rapport au silicium, la deuxième couche (H2) auxiliaire étant si mince que les sillons (H) auxiliaires ne sont pas remplis,
- dans lequel on dépose et on attaque latéralement un deuxième matériau, qui peut être attaqué sélectivement par rapport au premier matériau, jusqu'à ce que le deuxième matériau ne soit plus présent à l'intérieur des sillons (H) auxiliaires que sous la forme de structures (ST) en forme de bande,
- dans lequel on élimine les parties mises à nu de la deuxième couche (H2) auxiliaire sélectivement par rapport aux structures (ST) en forme de bande jusqu'à ce que des parties de l'espaceur soient mises à nu,
- dans lequel on attaque du silicium jusqu'à ce que l'espaceur (R) soit séparé, de sorte que la première partie de l'espaceur (R1) soit séparée électriquement de la deuxième partie de l'espaceur (R2),
- dans lequel on élimine, en utilisant la deuxième couche (H2) auxiliaire et la première couche (H1) auxiliaire en tant que masque, des parties du noeud (SP) de mémoire et on les remplace par du matériau isolant, de sorte que le noeud (SP) de mémoire ne soit plus voisin du substrat (1) que par sa première partie et que par sa deuxième partie,
- dans lequel on structure l'espaceur (R) séparé.

7. Procédé suivant la revendication 6,
- dans lequel, après séparation de l'espaceur (R), on diffuse dans un stade de recuit, de la substance de dopage implantée dans la première partie de l'espaceur (R1).

8. Procédé suivant l'une des revendications 6 à 7,
- dans lequel, après modification de l'isolement (I) et du noeud (SP) de mémoire, on dépose du matériau isolant et on l'attaque latéralement jusqu'à ce que la partie restante de l'espaceur (R1) soit mise à nu,
- dans lequel on élimine la partie restante de l'espaceur (R1),
- dans lequel on dépose une troisième couche (H3) auxiliaire en une épaisseur telle que les sillons (H) auxiliaires ne soient pas remplis,
- dans lequel on dépose un troisième matériau et on l'attaque latéralement jusqu'à ce que le troisième matériau ne soit plus présent qu'à l'intérieur des sillons (H) auxiliaires et on forme dans les sillons (H) auxiliaires, respectivement, un masque (M) en forme de bande,
- dans lequel on élimine des parties mises à nu de la troisième couche (H3) auxiliaire sélectivement par rapport au masque (M),
- dans lequel on élimine des parties de la première couche (H1) auxiliaire qui sont à l'extérieur du masque (M) et on met à nu des parties du substrat (1) qui sont sous-jacentes,
- dans lequel on attaque le substrat (1) sélectivement par rapport au masque (M) de manière à produire des signaux (G) isolants,
- dans lequel on élimine le masque (M) et la première couche (H1) auxiliaire,
- dans lequel on produit les deuxièmes zones (S/D2) de source/drain dans des parties du substrat (1) disposées auparavant en dessous du masque (M),
- dans lequel on produit les sillons (G) isoiants de façon à ce qu'ils soient plus profords que les deuxièmes zones (S/D2) de source/drain.

9. Procédé suivant la revendication 8,
- dans lequel l'épaisseur de la troisième couche (H3) auxiliaire est égale à la somme de l'épaisseur de l'espaceur (R) et de l'épaisseur de la deuxième couche (H2) auxiliaire.

10. Procédé suivant l'une des revendications 1 à 9,
- dans lequel après la finition du noeud (SP) de mémoire on diffuse de la substance de dopage dans un stade de recuit du noeud (SP) de mémoire dans le substrat (1) et on y forme la première zone (S/D1) de source/drain.
